# EUROPEAN PATENT SPECIFICATION

(11) **EP 0 704 094 B1**
(45) Date of publication and mention of the grant of the patent: **08.08.2001**
(21) Application number: 94915663.2
(22) Date of filing: 20.05.1994
(51) Int. Cl.: H01B 1/12, C09K 11/06, H05B 33/14, H05B 33/26, C08F 8/44, C08G 61/00, H05B 33/10

(54) **POLYMERS FOR OPTICAL DEVICES**
POLYMERE FÜR OPTISCHE VORRICHTUNGEN
POLYMERES POUR DISPOSITIFS OPTIQUES

(30) Priority: 10.06.1993 GB 9311992; 05.11.1993 GB 9323004; 18.03.1994 US 210327
(43) Date of publication of application: 03.04.1996
(73) Proprietor: Cambridge Display Technology Limited, Cambridge, CB1 2JB (GB)
(72) Inventor: HOLMES, Andrew, Bruce, Cambridge CB1 2JB (GB); FRIEND, Richard, Henry, Cambridge CB3 9LG (GB); MORATTI, Stephen, Carl, Cambridge CB4 1JQ (GB); BAIGENT, Derek, Ralph, Cambridge CB3 0DS (GB); BRADLEY, Donal, Donat, Conor 86 Green Oak Avenue, Sheffield S17 4FT (GB); CERVINI, Raoul, Cambridge CB4 3HE (GB); GREENHAM, Neil, Clement, Cambridge CB4 1NE (GB); HAMER, Peter, John, Cambridge CB4 2PR (GB)
(74) Representative: Daniels, Jeffrey Nicholas
(86) International application number: GB9401118
(87) International publication number: WO9429883

(56) References cited:
- WO-A-90/13148
- WO-A-92/03490
- WO-A-92/03491

## Description

### Field of the Invention

This invention relates to conjugated polymers incorporating electron-withdrawing groups for use in optical devices, such as electroluminescent devices. Methods for their manufacture, and optical devices incorporating the polymers are also provided.

### Background of the Invention

Optical devices such as light-emitting devices have been described using both organic polymers and organic molecular compounds. The advantages of these devices over other technologies include the possibility of wide area displays, low d-c working voltages, simple manufacture and light emission encompassing the full visible spectrum. In general, devices made from polymeric materials have additional advantages of mechanical and thermal stability over those made from sublimed molecular films, and can be deposited from solution either as a precursor or a fully conjugated polymer rather than by vapour phase deposition.

Various types of polymers for use in light-emitting devices have previously been described. Fully conjugated polymers (or derivatives thereof) such as poly(p-phenylenevinylene) (PPV) (Burroughes et al., Nature, 1990, 347, 539), poly (3-alkylthiophene)s (Ohmori, Y., Uchida, M., Muro, K., and Yoshino, K., Solid State Commun., 1991, 80, 605) and poly-(p-phenylene) (PPP) (Grem, G., Leditzky, G., Ullrich, B., and Leising, G., Adv. Mater., 1992, 51, 383) amongst others have been used. Improved device efficiencies can be achieved using copolymers containing interrupted conjugation sequences (P.L. Burn, et al., Nature, 1992, 356, 47) and a variety of other materials have been reported (Holmes, A.B. Synth. Met., 1993, 57/1, 4031-4040).

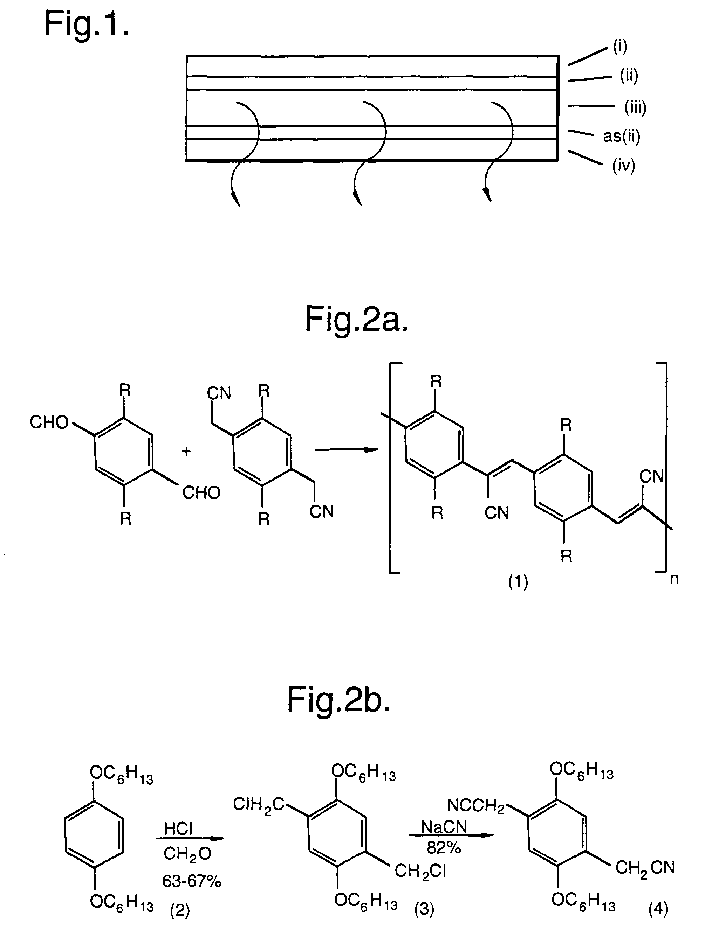

The basic structure of a typical light-emitting device is shown in Figure 1, and comprises an electron injecting cathode (i), a semi-transparent anode (iv), and an emissive layer (iii) sandwiched between two optional charge transport layers (ii). Light emission occurs when electrons and holes are injected and a hole encounters a negatively charged species in the emissive layer. The resulting singlet exciton can decay by radiative emission of a photon of visible light.

The barrier to hole injection for the majority of simple conjugated polymers such as PPV and PPP is lower than that for electron injection. To improve electron injection into these polymers, and therefore increase the opportunity for singlet exciton formation, two approaches have been used. Firstly, by employing low-work function metals such as calcium as the cathode, efficiencies can in some cases be increased 50-100 fold over metals such as aluminium (Braun, D., and Heeger, A.J., Appl. Phys. Lett., 1991, 58, 1982). The main drawback to this approach is the extreme air and moisture sensitivity of substances such as calcium, which would probably preclude their use in commercial devices. It is advantageous to employ stable, high work-function metals for the cathode. Secondly, more balanced charge injection can be achieved through the use of one or more charge transport layers between the emissive layer and the cathode or anode. A further rise in device efficiency (measured as photons emitted/electrons injected) is attainable by matching electron and hole injection, for example by heterojunction engineering using transport layers (ii) (P.L. Burn, et al., in Electrical, Optical, and Magnetic Properties of Organic State Solid Materials (MRS Symposium N, Fall Meeting Boston 1991), L.Y. Chiang, A.F. Garito and D.J. Sandman, Eds., Mats. Res. Symp. Proc. 1992, 247, 647-654; A.R. Brown, et al., Appl. Phys. Lett., 1992, 61, 2793-2795).

### Summary of the Invention

The present invention provides a semiconductive conjugated polymer comprising arylene vinylene units forming at least part of the polymer main chain in which a solubilising group is present on at least some of the arylene moieties so as to render the polymer solution processible in either a polar solvent or a non-polar solvent with the proviso that if the solubilising group is alkoxy, it has more than 4 carbon atoms, and an electron-withdrawing group is conjugatively linked to at least some of the vinylene moieties, wherein the solubilising group and the electron-withdrawing group are selected so that the polymer emits radiation when excited to luminesce.

The presence of the electron-withdrawing groups reduces the barrier to electron-injection into the polymer thereby offering the opportunity to improve the efficiency of the device in electroluminescence when constructed with higher work function cathodes. Typical internal quantum efficiencies for electroluminescence of the polymers of the present invention are above 0.1%, preferably in the range 0.1 to 0.4% (when present in a single-layer electroluminescent device). This represents a significant increase in efficiency as compared with corresponding polymers in the absence of the electron-withdrawing groups. By raising the electron affinity of the polymer with the electron withdrawing groups, the rate of electron-injection into the polymer increases.

Advantageously, the electron-withdrawing group may be selected to modulate the optical properties of the polymer, for example by altering the refractive index of the polymer or by modulating the wavelength of radiation emitted in electroluminescence. Modulation of the optical properties of polymers is further discussed in International Patent Publication No. WO92/03490 of the present applicant. For example, the electron-withdrawing group may be conjugatively linked to the vinylene group through a phenyl group so as to alter the band gap of the polymer.

Suitable electron-withdrawing groups include nitrile, acid amide, carboxyl, ketone, phosphinoyl, phosphonate and esters. Nitrile groups are preferred. Other electron-withdrawing groups may be selected provided that their presence in the polymer does not interfere with the electroluminescent properties thereof. Sulfones such as PhSO₂- are a possibility. Useful electron-withdrawing groups are those which have a positive Hammett sigmaₚ substituent constant.

Moreover, the electron-withdrawing groups should preferably be selected so that polymers are readily synthesised and should not therefore interfere with the polymerization process.

For instance, poly(2-nitro-1,4-phenylenevinylene) cannot be synthesised by the standard Wessling route, although copolymers have been suggested (Jung-il, J., Sang-Hyeun, Y., Hong-Ku, S., J. Polymer Sci., Part B, Polymer Phys., 1993, 31, 87).

The presence of the solubilising group in the polymer facilitates both the manufacture of the polymer and assists the processibility of the polymer. It is unnecessary to have a solubilising group on every single monomer unit of the polymer provided that the solubilising groups are present in sufficient concentration to render the polymer usefully processible. Preferably, at least one in four of the monomer units should include a solubilising group, most preferably all the monomer units. The exact solubilising group is not critical provided that it is compatible with the processing medium used for laying down the polymer as a film. Typical solubilising groups for non-polar solvents include long chain alkyl or alkoxy groups, linear or branched, advantageously having four or more carbon atoms preferably five or more. Preferred solubilising groups include hexyloxy groups and 2-ethylhexyloxy groups. For polar solvents such as aqueous solvents, solubilising groups such as carboxylic acids or amines may be used.

The solubilising group may also be selected to modulate the optical properties of the polymer through conjugative, inductive or steric influences. For further detail see International Patent Publication No. WO92/03490.

In the context of the present application a conjugated polymer is understood to be a fully or partially conjugated polymer which possesses a delocalised pi-electron system along the polymer main chain to an extent sufficient to confer semiconducting properties on the polymer and to give the polymer the ability to support positive and negative charge carriers with high mobilities along the main chain. The pi-electron system may be interrupted by unconjugated regions or may be uninterrupted in a fully conjugated polymer. The effects of full and partial conjugation are further discussed in WO92/03490, the subject-matter of which is hereby incorporated by reference. In one embodiment of the present invention, the polymer is a substantially fully conjugated poly(arylene vinylene) polymer and may be a homopolymer or a copolymer.

Throughout this specification the term arylene is intended to include in its scope all types of arylenes including heteroarylenes, as well as arylenes incorporating more than one ring structure, including fused ring structures. Preferred arylene moieties used in the present invention include paraphenylene, thienylene and naphthalene.

Further in accordance with the present invention, the arylene units may be selected to modulate the optical properties of the polymer, particularly by modulation of the semiconductor band gap of the polymer. For example, different arylene units may be selected so as to modulate the optical properties of the polymer so that electroluminescent emission can be made to occur in the infrared region of the spectrum, preferably in the region 700nm to 1100nm. Polymers 21 and 22 are capable of emitting in the infrared region.

By selection of the arylene units in the polymer it is also possible to alter the conjugation length in the polymer so as to modulate the optical properties of the polymer. For example, it is possible to modulate the optical properties to obtain electroluminescent emission in the blue region of the visible spectrum, for example in the region 400 to 510nm, advantageously 430 to 480 nm, preferably around 450nm. This is exemplified by polymer 29 in which interruption of the conjugation is achieved by selection of isopropyl substituents on one ring to give rise to steric deformation or twisting, and selection of meta substitution on another aryl fragment.

A preferred fully conjugated poly(arylene vinylene) polymer has the following general formula:

(̵Ar-vinylene-Ar'-vinylene)̵ₙ

in which Ar and Ar' are the same or different and represent arylene groups. Each vinylene is substituted with the electron withdrawing group X, and n represents the degree of polymerisation.

Preferably, the polymer has the general formula:

(̵Ar-CX=CH-Ar'-CH=CX)̵ₙ

in which the electron-withdrawing groups alternate in the 1 and 2 positions of the vinylene moiety. This is advantageous because it offers the most versatility and high yields in the synthesis.

In a preferred embodiment, the electron-withdrawing groups are present in a trans configuration so as to produce the thermodynamically preferred double bond geometry.

In a further embodiment of the present invention the polymer comprises unconjugated regions and conjugated regions which incorporate the arylene vinylene units. Preferably, the conjugated regions in the main chain comprise distyrylbenzene moieties which incorporate the arylene vinylene units. The distyrylbenzene moieties may be separated by an aliphatic linker group, for example in accordance with the following general formula: 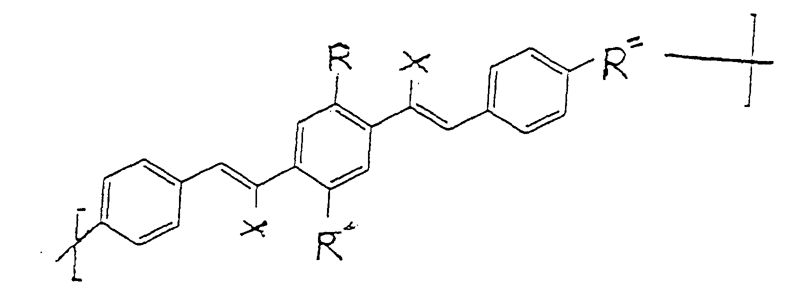 in which at least one of R and R' is a solubilising group, X is the electron-withdrawing group, and R" is the aliphatic linker group.

As a further development of the polymers in the present invention, it is possible to incorporate cross-linkable groups at the ends of substituent groups on the arylene moieties. For example, cross-linkable groups at the ends of alkyl substituents could allow in situ cross-linking. A further use of alkyl rather than alkoxy side chains would also blue-shift the electroluminescent emission of the polymer.

In a further aspect, the present invention provides an optical device which comprises a first contact layer, and a semiconductive layer in contact with the first contact layer, wherein the semiconductive layer comprises an emissive layer of a semiconductive conjugated polymer comprising arylene vinylene units forming at least part of the polymer main chain, a solubilising group is present on at least some of the arylene moieties so as to render the polymer solution processible in either a polar solvent or a non-polar solvent, with the proviso that if the solubilising group is alkoxy, it has more than 4 carbon atoms, and an electron-withdrawing group is conjugatively linked to at least some of the vinylene moieties so that the polymer emits radiation when excited to luminesce.

The optical device may comprise a photoluminescent device in which the polymer emits radiation upon application thereto of radiation of sufficient energy to excite the polymer to luminesce. The optical device preferably comprises an electroluminescent device wherein the first contact layer is in contact with a first surface of the semiconductive layer, and a second contact layer is in contact with a second surface of the semiconductor layer. In the electroluminescent device the polymer emits radiation upon application of an electric field between the first and second contact layers.

Electroluminescent devices of this general type are discussed in further detail in International Patent Application, publication no. WO 90/13148 (or corresponding US Patent No. 5247190) of the present applicants. In addition to electroluminescent devices and other optical devices, these polymers may also be used either as single layers or as components in multiple layers in photovoltaic devices or in photoconductive devices.

Preferably, the semiconductive conjugated polymer used in the devices is as discussed above.

The polymers according to the present invention can be deposited as high quality transparent layers by spin-coating solutions of the polymer. In the electroluminescent device, the polymers exhibit improved quantum efficiencies as compared with other comparable conjugated polymers, especially when employed with stable high work-function metals. Because the electron-withdrawing groups apparently stabilize the negative charge carriers to such an extent that the barrier to electron-injection is greatly reduced, hole injection or transport may now be the limiting process for maximum device efficiency.

Preferably, the semiconductive layer in the electroluminescent device further comprises a hole-transporting polymer layer between the emissive layer and the first contact layer. Surprisingly, such devices exhibited typical EL internal quantum efficiencies of 2 to 4% and in some cases EL efficiencies up to 10% were achieved. The hole-transporting polymer layer can be selected to match the first contact layer for hole injection. Preferably, the first contact layer comprises indium-tin oxide and the hole transporting polymer comprises poly(paraphenylenevinylene), polyalkylthiophene or polyphenylene. Additionally, the polymer can be chosen to match an air-stable metal for electron injection. Any suitable metal or alloy may be used such as aluminium or gold. A preferred metal is aluminium. Calcium may also be used as the metal However, calcium is not air stable. Other hole transporting materials might for instance be derived from triarylamines.

The first or second contact layer may also be in contact with a substrate, such as a glass substrate. In some applications, flexible substrates may be used, such as polyester substrates, for example PET substrates. In one embodiment of the invention described in further detail below, the second contact layer is in contact with an electrically-active substrate such as silicon or germanium, optionally doped to achieve the necessary degree of matching in the device. In this embodiment, the semiconductive conjugated polymer functions as an optical interconnect and can form part of a larger device using a chip or wafer as the substrate.

In a further aspect of the present invention there is provided a method of making an optical device which comprises:
(a) providing the second contact layer in contact with the substrate;
(b) forming a layer of the semiconductive conjugated polymer on the second contact layer;
(c) forming a layer of the hole-transporting polymer on the layer of the semiconductive conjugated polymer; and
(d) forming the first contact layer on the layer of the hole-transporting polymer.

In accordance with this method, electroluminescent devices such as devices incorporating optical interconnects as described above can be fabricated in a configuration which is inverse as compared with the conventional method of fabrication.

Advantageously, the second contact layer is evaporated onto the substrate in step (a). This provides a useful method of coating the substrate with suitable metals or alloys, such as aluminium. The semiconductive conjugated polymer may be applied in step (b) from solution although this polymer could be applied in soluble precursor form and thermally converted (for example as described in further detail below). The hole-transporting polymer is generally applied in step (c) in the form of a soluble precursor. This precursor form is subsequently thermally converted to form the hole-transporting polymer. Again, the hole-transporting polymer could be applied in soluble form. Preferably, the first contact layer is applied in step (d) by a vapour phase method, such as sputtering. This is particularly useful in the application of contact layers such as indium-tin oxide.

The present invention also provides a method of making the semiconductive conjugated polymer. The method comprises reacting a first compound of general formula

X-CH₂-Ar-CH₂-X

with a second compound of general formula

O=(R)C-Ar'-C(R)=O

under conditions to produce a polymer comprising at least some regions of

-Ar-CX = RC-Ar'-CR = CX-

in which Ar and Ar' are the same or different and represent arylene moieties or arylene-containing moieties, at least some of which are substituted with a solubilising group, X is an electron-withdrawing group and R is alkyl, aryl or hydrogen.

The reaction is preferably performed under base catalysis using any suitable base. Advantageously, the base comprises potassium t-butoxide, tetra-N-butylammoniumhydroxide or mixtures thereof. Advantageously, the reaction is performed in solvent, preferably t-butyl alcohol and/or tetrahydrofuran (THF), more preferably a 50/50 mixture of the two. Temperature ranges for the reaction are typically from 25 to 60°C, preferably around 35°C to 50°C. Higher temperatures and more polar solvents are generally undesirable because they tend to promote unwanted side reactions. The time for the reaction is generally in the range 1 minute to 12 hours, usually in the range 3 to 4 hours.

The second compound may be an aldehyde or a ketone, preferably an aldehyde with R=H. The exact reactant compounds are selected in accordance with the products to be produced.

In this embodiment of the present invention the Knoevenagel condensation of arene diacetonitriles and dialdehydes has been used to produce a range of soluble alternating poly(arylenevinylene) polymers with pendant nitrile groups (Scheme 1).

The condensation reaction of aromatic dialdehydes and dinitriles which forms the brightly coloured polymers (Scheme 1, R=H or OMe) has been mentioned in around 12 papers and patents since 1960. In all cases the products were insoluble, infusible and were only characterised by i.r. and u.v. spectroscopy, and electrical (conductivity) and thermal (TGA) measurements, although a solid state NMR study (Schröter, B., Hörhold, H.H., and Raabe, D., Makromol. Chem., 1981, 182, 3185) and an electrochemical study (Helbig, M., Hörhold, H.H., Makromol, Chem., 1993, 194, 1607) have been reported. The synthesis of these unprocessible polymers was first reported by Lenz, R.W., and Handbuts, C.E.J. Org. Chem., 1960, 25, 813, and later references are: Debord, D., and Gole, J. Bull. Soc. Chim. Fr., 1971, 1393; Debord, D., and Gole, J., Bull. Soc. Chim. Fr., 1971, 1401; Debord, D., and Gole, J., Compt. Rend., 1964, 259, 3022; Funke, W., and Schwetze, E.C., Makromol. Chem., 1964, 74, 71; Klemm, D., Klemm, E., Jerusel, H., Drefahl, G., Hörhold, H., J. Prakt. Chem., 1978, 320, 767). A number of patents describe their use in electrophotographic processes (Peters, M., Verbunt, J.A., EP-A-24762), and as photoconductors (Drefahl, G., Hörhold, H.H., Opfermann, J., Ger (East) 75233). These materials are insoluble, unprocessible and oligomeric with degree of polymerisation n < 7-8 as evidenced by their i.r. spectra and elemental analyses. This is mainly due to the insolubility of these compounds in the solvent used for the polymerization (almost always ethanol or methanol). These polymers are quite useless for electroluminescent devices as described in this patent due to the impossibility of preparing thin films with them, and have not been identified as candidates for electroluminescence studies in any previous paper.

A useful route to produce the embodiment of the polymer in which the conjugation is interrupted requires Ar' to comprise the unit Ar"-R"-Ar"' in which Ar" and Ar"' are the same or different and represent arylene moieties, and R" represents an aliphatic linker group. In this way, the conjugation of the polymer main chain can be interrupted by the introduction of the aliphatic linker group. The linker group is conveniently introduced into the polymer by any suitable method. For example, where R" is -O-(CH₂)₈-O-, the linker can be introduced as 1,8-dibromooctane to alkylate hydroxy derivatives of the two moieties Ar" and Ar"'. This approach can be extended to any suitable alkylating agent, such as any dihaloalkane.

A key step in the present invention is to prepare polymers with long chain solubilising groups, and to use a synthetic process which can be extended to include the synthesis of copolymers. By including long chain alkoxy or alkyl groups as solubilising substituents on the aromatic ring we found that it is possible to produce soluble versions of the cyano-substituted polymers. Additionally, the solubilising groups allowed the condensation process to produce high molecular weight materials (gel permeation analysis against polystyrene standards).

The possibility also exists that a degree of cross-linking may be occurring during the polymerization reaction. Evidence for this cross-linking may be found in the NMR spectral data. It may therefore be advantageous to permit a degree of cross-linking to occur in order to achieve the advantageous properties including fine-tuning of the colour of the polymer, as described above.

In a further aspect of the present invention there is provided a method of making a semiconductive conjugated polymer comprising arylene vinylene units forming at least part of the polymer main chain, to which is conjugatively linked an electron-withdrawing group. The method comprises:
(a) providing a solution-processible precursor polymer comprising arylene-1,2-ethanediyl units forming at least part of the polymer main chain, in which the electron-withdrawing group is linked to the polymer main chain and a leaving group is present on at least some of the ethanediyl units so as to render the precursor polymer solution-processible, and
(b) heating the precursor polymer under conditions to eliminate the leaving group, thereby converting the arylene-1,2-ethanediyl units into arylene vinylene units.

In accordance with this aspect of the invention, the semiconductive conjugated polymer may be provided without solubilising groups by using a solution-processible precursor polymer. The leaving group renders the precursor polymer solution-processible by acting as a solubilising group and/or by allowing the polymer to remain flexible and assume conformations which interact favourably with suitable solvents.

Advantageously, the precursor polymer is of the general formula (̵Ar-CXY-CH₂)̵ₙ wherein Ar is an arylene group, X is the electron-withdrawing group and Y is the solubilising group. The electron-withdrawing group is as defined above. Any suitable solubilising group Y may be used, preferably a tetrahydrothiophenium solubilising group¾. Preferably, the precursor polymer is formed from a monomer of general formula YCH₂-Ar-CXYH.

### Brief Description of the Drawings

The present invention will now be discussed in further detail by way of example only and with reference to the attached drawings in which:
FIGURE 1 shows a schematic representation of a typical electroluminescent device;
FIGURES 2(a to d) and 3(a to e) show the structural formulae of compounds and polymers discussed below;
FIGURE 4 shows an electroluminescence emission spectrum of CN-PPV (1);
FIGURE 5 shows a graph of voltage vs current for a device comprising ITO/CN-PPV/Al;
FIGURE 6 shows a graph of efficiency vs current for a device comprising ITO/CN-PPV/Al;
FIGURE 7 shows a graph of voltage vs current for a device comprising ITO/PPV/CN-PPV/Al;
FIGURE 8 shows a graph of efficiency vs current for a device comprising ITO/PPV/CN-PPV/Al;
FIGURE 9 shows an EL emission spectrum of a device comprising ITO/PPV/polymer(11)/Al; and
FIGURE 10 shows an EL emission spectrum of a device comprising ITO/PPV/condensation polymer of (14)+(7)/Al;
FIGURE 11 shows absorption and EL emission spectra of a device comprising ITO/PPV/polymer (28)/Ca;
FIGURE 12 shows a graph of current and luminance vs voltage for a device comprising ITO/PPV/polymer (28)/Ca;
FIGURE 13 shows a graph of quantum efficiency vs current for a device comprising ITO/PPV/polymer (28)/Ca;
FIGURE 14 shows absorption and PL emission spectra of polymer (21) and an EL emission spectrum for a device comprising ITO/PPV/polymer (21)/Ca; and
FIGURE 15 shows absorption and PL emission spectra of polymer (22) ;
Figure 16 shows absorption and EL emission spectra of a device comprising ITO/PPV/polymer (37)/Ca;
Figure 17 shows absorption and EL emission spectra of a device comprising ITO/PPV/polymer (42)/A1;
Figure 18 shows a graph of EL efficiency versus current for a device comprising ITO/PPV/polymer (42)/A1;
Figure 19 shows the EL emission spectrum of a device fabricated by an inverse sequence comprising ITO/PPV/polymer (1)/A1/n-type silicon; and
Figure 20 shows a graph of luminance versus electric field for an EL device fabricated by an inverse sequence comprising ITO/PPV/polymer (1)/A1/n-type silicon.

### Description of the Preferred Embodiments

### Synthesis of Starting Materials and Polymers

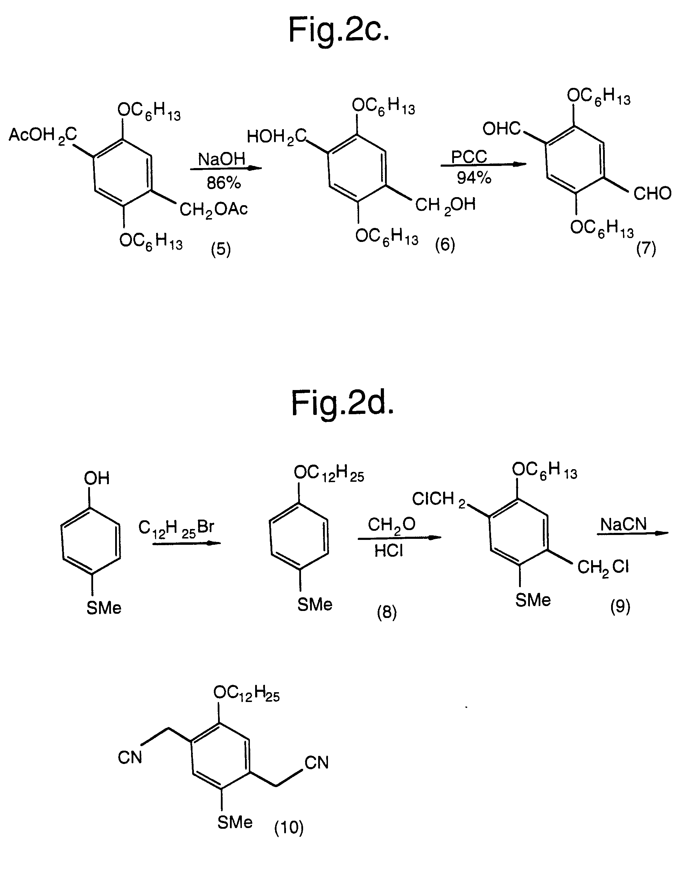

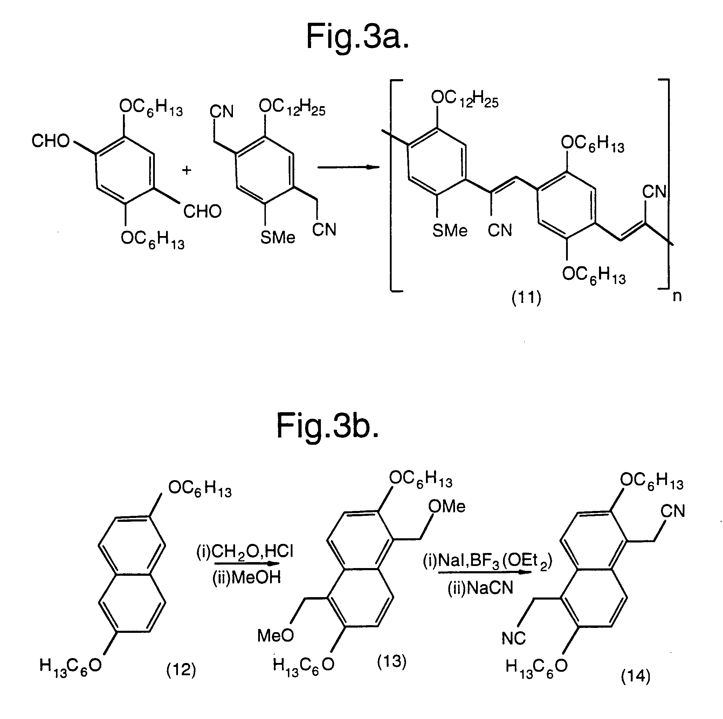

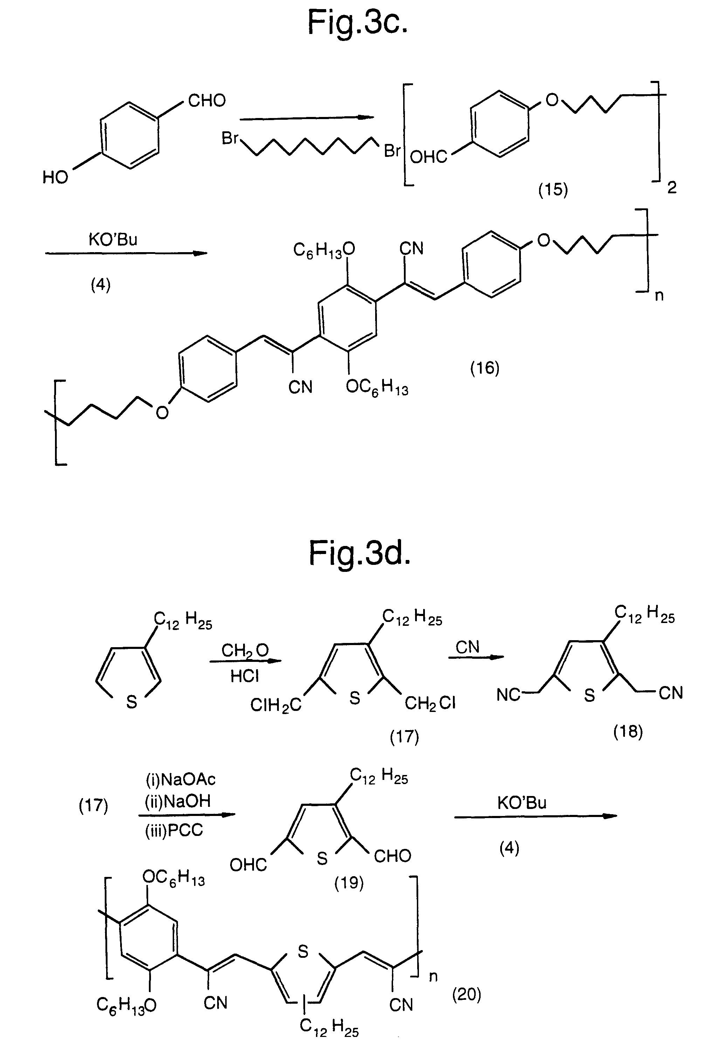

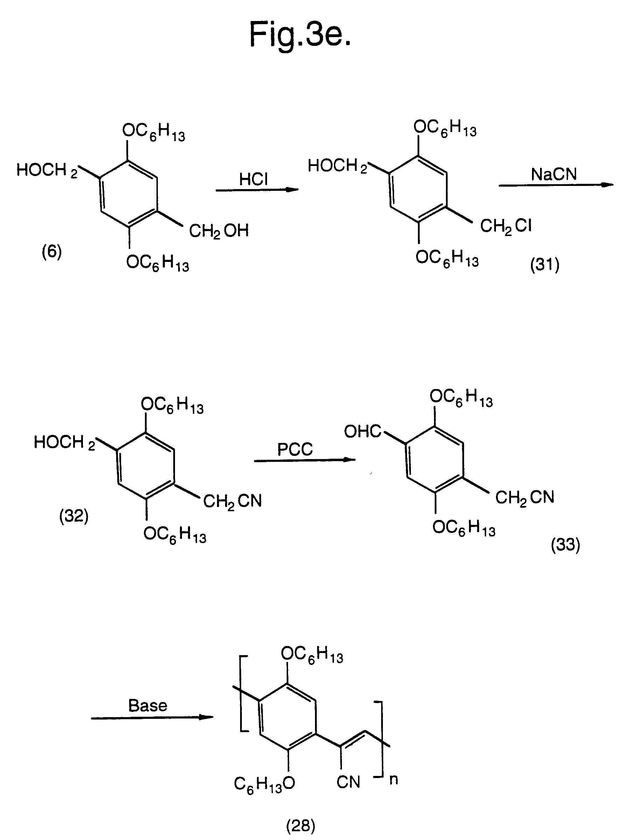

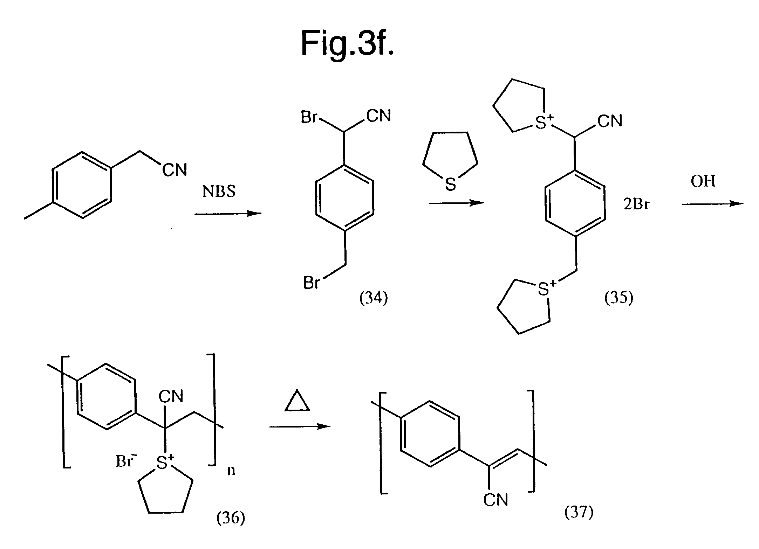

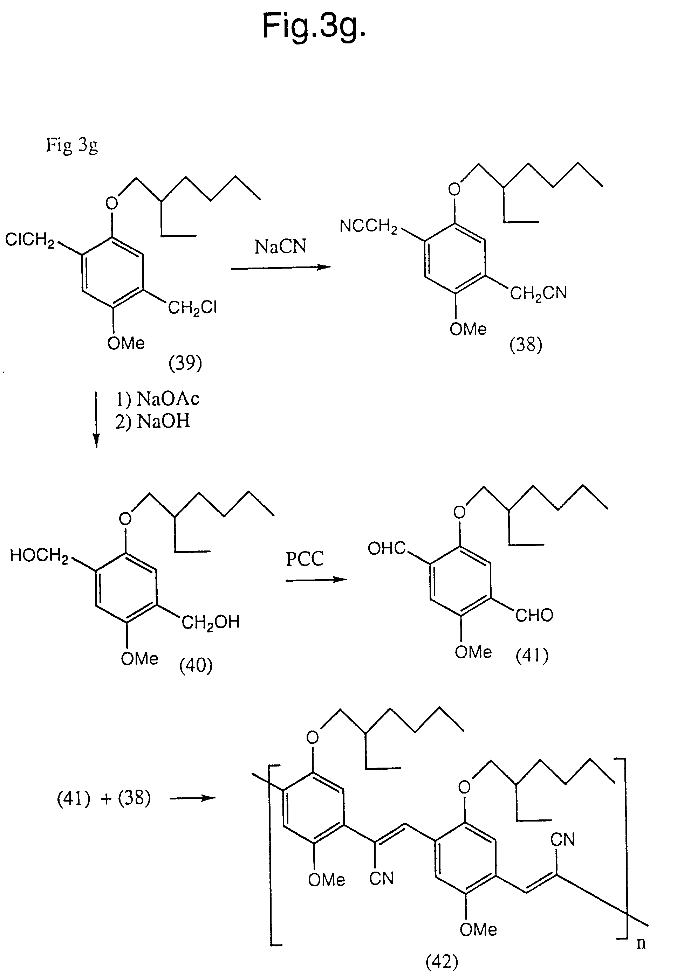

Referring to Figures 2 and 3, bischloromethylation of dihexyloxybenzene (2) produced (3) in 63-67% yield. Treatment of (3) with sodium cyanide in DMF at 60°C gave the dinitrile (4) in 82% yield.

The bischloromethyl compound (3) cannot be converted directly with hydroxide into the diol (6) owing to the likelihood of polymerisation. Thus, it was first converted into the diacetate (5), which then could be safely hydrolyzed to give the diol (6). Oxidation of (6) with pyridinium chlorochromate (PCC) gave the dialdehyde (7) in excellent yield.

The condensation of the dialdehyde (7) with the dinitrile (4) was investigated under a number of conditions. While methanol or ethanol were previously reported as the preferred solvents for such reactions, in the present case only oligomers were produced under these conditions owing to the insolubility of the reaction products. By using less polar solvents such as dichloromethane, some polymer was produced, but in low yield, and the material did not appear fluorescent. However, the preferred reaction solvent was t-butyl alcohol with potassium t-butoxide as the preferred base catalyst; a brightly coloured product (1; R=OC₆H₁₃) (CN-PPV) was produced in this solvent in good yield after only a few minutes at 50°C. However, not all of the subsequent polymerisations with other substrates were equally rapid, and in general most required 3-4 h reaction time.

The peak molecular weight distribution of the polymer (1;R = OC₆H₁₃) was measured by gel-permeation chromatography (GPC) (polystyrene standards) indicating a peak at approximately 10,000 Daltons (Mₙ 8,900; M_{w} 30,000). The aromatic portion of the ¹H NMR spectrum usually showed only 3 peaks, indicating the absence of noticeable side-reactions (such as Michael-addition to the alkene groups). The solid state absorbance of a thin film (300 nm) of the polymer was similar to that of poly[2-methoxy-5-(2'-ethylhexyloxy)-1,4-phenylenevinylene] (MEH-PPV) with a main broad absorbance peak at 490 nm (onset of absorbance at ca. 600 nm). The photoluminescence spectrum was slightly more red-shifted than MEH-PPV, with a single broad emission centred around 1.93 eV.

Light emitting devices were constructed by spin-coating a solution of the polymer in chloroform onto indium-tin oxide (ITO) substrates, followed by evaporation of a metal as the top electrode (the thickness of the organic layer was around 300 nm, which required driving voltages of 30-35 V). The electroluminescence spectrum proved to be identical to the spectrum measured by photoluminescence. Surprisingly, there was no noticeable difference in quantum efficiencies between the use of aluminium or calcium as the cathode, which is most unusual in these devices. Both metals exhibited about 0.1-0.3% internal quantum efficiency, which indicates that electron injection is no longer the limiting factor for efficient light output.

With the aim of further improving the balance of electron and hole injection, a two layer device was constructed. A layer of PPV was placed between the nitrile polymer and the ITO. These devices produced light with an emission spectrum similar to that of CN-PPV, but with greatly improved efficiencies. Maximum internal quantum efficiencies of 3% were achieved using calcium or aluminium as the cathode, decreasing slightly to 1% with gold as the cathode. Injection and transport of holes in PPV is well known (A.R. Brown, et al., Chem. Phys. Lett., 1992, 200, 46-54), and it is believed that here the PPV acts primarily as a hole-transporting layer. It is believed that the efficiency improvement is due to confinement of charge carriers at the interface between the PPV and the CN-PPV due to differences in the energies of the HOMO and LUMO levels and the band offsets resulting at the interface between the two polymers.

One of the advantages of the condensation route to electron withdrawing group-substituted polymers is that a wide range of polymers and copolymers can be synthesised. The standard Wessling route to PPV polymers requires the intermediacy of a semi-stable quinoidal intermediate. This requirement may limit the range of monomers which can be employed. To exemplify the breadth of the condensation route and the range of colours that can be obtained from polymers produced by the condensation process, some examples are given below.

Alternative possible rates to these copolymers are: (1) Dehydrohalegenation of p-(bischloromethyl)cyano-methyl benzenes (see Hsieh, Polym. Mater. Sci. Eng., 1992, 67, 252) or NCCHBr-Ar-CHBrCN (see Chem. Abstr., 1985, 103, 178741a; 1987, 107, 237406c); (2) Wittig condensation polymerization described by the oligomer examples reported by Kossmehl and Nuck (Chem. Ber. 1979, 112, 2342).

In the present case, 4-(Methylmercapto)-phenol was alkylated with bromododecane to give (8), which was bischloromethylated (under forcing conditions) to yield (9). Treatment of (9) with sodium cyanide furnished the dinitrile (10). Copolymerisation of (10) and (7) (1:1) gave a red-orange copolymer (11) with bright orange fluorescence. The blue shift of this polymer as compared to that of (1) may be due to the greater ability of oxygen (compared to sulfur) to interact with the aromatic rings, thus lowering the HOMO-LUMO gap.

A two-layer device with structure ITO/PPV/(11)/A1 was constructed and tested. It emitted a bright yellow-orange light with a maximum efficiency of 2%.

Alternatively, a copolymer based on the dialkoxy-naphthalenediacetonitrile (14) was prepared.
Bischloromethylation of the dialkoxynaphthalene (12) gave an unstable bischloromethyl substituted derivative, which upon attempted recrystallisation from methanol produced (13). Treatment of (13) with sodium iodide and boron trifluoride etherate gave a di-iodomethylnaphthalene, which converted into the nitrile (14) by an analogous method as previously described. A bright yellow fluorescent copolymer was produced from the cocondensation of (7) and (14). The blue shift of the absorbance of this last polymer [as compared with CN-PPV (1;R = OC₆H₁₃)] is probably due to the larger steric requirements of the naphthyl-group(peri-H), leading to greater twisting of the linking double bonds out of effective conjugation and shorter conjugation lengths, possibly as a result of crosslinking reactions. This device showed an efficiency of 2%.

Main chain polymers interrupted by regular cyano-substituted distyrylbenzene units can be produced by similar reaction sequences. The bis-aldehyde (15) was produced by the alkylation of p-hydroxybenzaldehyde with 1,8-dibromooctane. Condensation of (15) with (4) produced a bright yellow polymer (16).

Heterocycles can also be easily included in the copolymer chain. The literature records the preparation of an insoluble cyano-substituted alternating polymer derived from thiophene-2,5-diacetonitrile and thiophene-2,5-dicarboxaldehyde (Kossmehl, G. Ber. Bunsenges. Phys. Chem., 1979, 83, 417) and copolymers based on the thiophene-2,5-dicarboxaldehyde and 2,5-dimethoxy-terephthaldehyde (H. Hörhold, Z. Chem., 1972, 12). The bischloromethylation of 3-dodecylthiophene gave the unstable product (17), which was immediately treated with cyanide to give the bisnitrile (18). Alternatively, the bis-aldehyde (19) can be synthesized from (17) in 3 steps in an analogous fashion to before. Condensation of (18) with (7) gave a purple polymer (onset of absorbance of 670 nm).

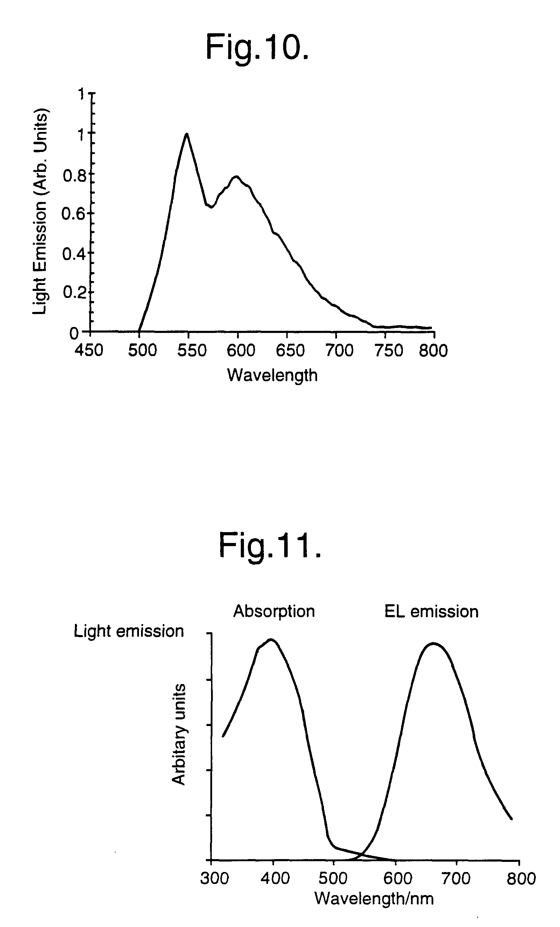

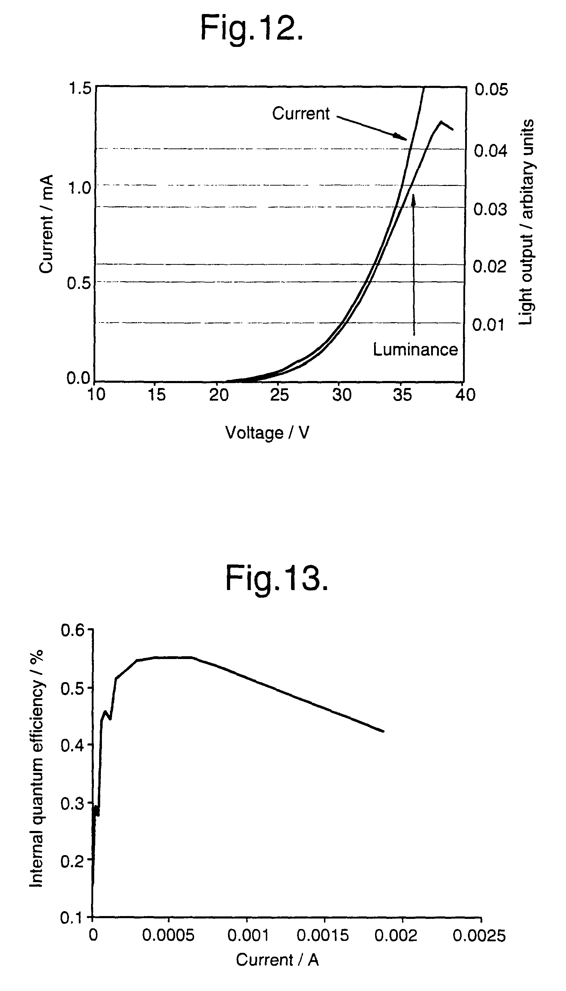

It is possible to synthesise alternative polymers such as (28) by self-condensation of the monomer (33); however, the synthesis of (33) is harder and less efficient than the alternative syntheses of the dinitrile (4) and dialdehyde (7). This probably diminishes the attractiveness of this route. The absorpiton and EL emission spectra (Fig. 11), the current and luminance versus voltage (Fig. 12) and the efficiency versus current (Fig. 13) for polymer (28) are shown. EL emission from polymer (28) is less efficient than that from polymer (1;R=OC₆H₁₃) under comparable device conditions (see Example 2).

It is also possible to prepare by precursor routes homo and copolymers based on poly(arylenevinylene)s bearing electron withdrawing substituents on the vinylidene linkages or the aromatic rings. This is illustrated with the preparation of the cyano-substituted sulfonium precursor (36). To this end, p-tolunitrile was brominated with N-bromosuccinimide to give the dihalide (34). The bromine groups were then substituted with tetrahydrothiophene to give the bis-sulfonium salt (35). This was polymerised with base to give the precursor polymer (36) which is soluble in aqueous methanol. Thin films of (36) can be prepared by spin coating from a suitable solvent and then thermally converted to yield the cyano-substituted homopolymer PPV analogue (37) which fluoresces orange under UV light. One of the advantages of this route is that multilayer devices can be easily constructed, as the converted polymer is insoluble, and allows other electroactive polymers in solution to be spun on top. Single and two layer devices incorporating (37) were prepared and found to electroluminesce with an efficiency of up to 0.02%.

To increase the solubility of the cyano-polymers it is possible to use branched unsymmetrical solubilising side-groups. Thus, poly(2-methoxy-5-(2'-ethylhexyloxy)-cyanoterephthalylidene) (MEH-CNPPV) (42) was prepared via an analogous route as described previously for the dihexyloxy derivative (1;R = hexyloxy). The polymer proved to be processible in a wide variety of solvents (toluene, N-methylpyrrolidone, tetrahydrofuran, and cyclohexanone) and to exhibit a red-orange photoemission. Two-layer devices (ITO/PPV/MEH-CNPPV) were found to be extremely bright and efficient, with EL internal quantum efficiencies of ca. 10%. Owing to the excellent control in processibility and the favourable band offsets between the layers, good quality thin layer devices having turn on voltages below 5 V could be fabricated.

One advantage of the cyanopolymers is that they can be incorporated in efficient EL devices on a variety of substrates that could not normally be used because of poor matching of band gap to metal work function. It is expected that one important use for EL devices is in (for example) optical interconnects driven directly from semiconductor circuitry. Therefore, it is important to be able to construct devices where one of the electrode materials is silicon, germanium or similar. A device assembled by an inverse fabrication sequence with the structure n-type silicon/Al/CN-PPV (1)/PPV/ITO gave good, stable red emission with a maximum efficiency of 0.25%.

### Device Preparation

### Example 1

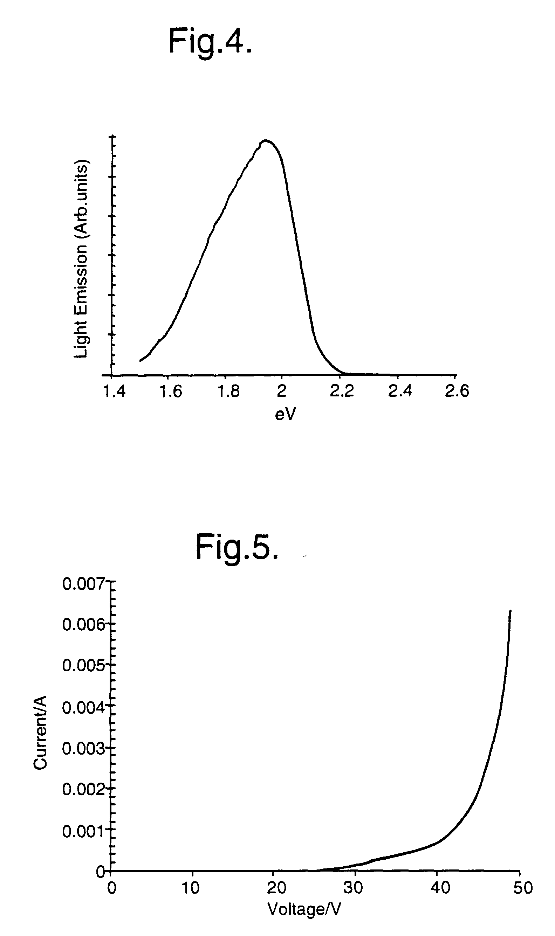

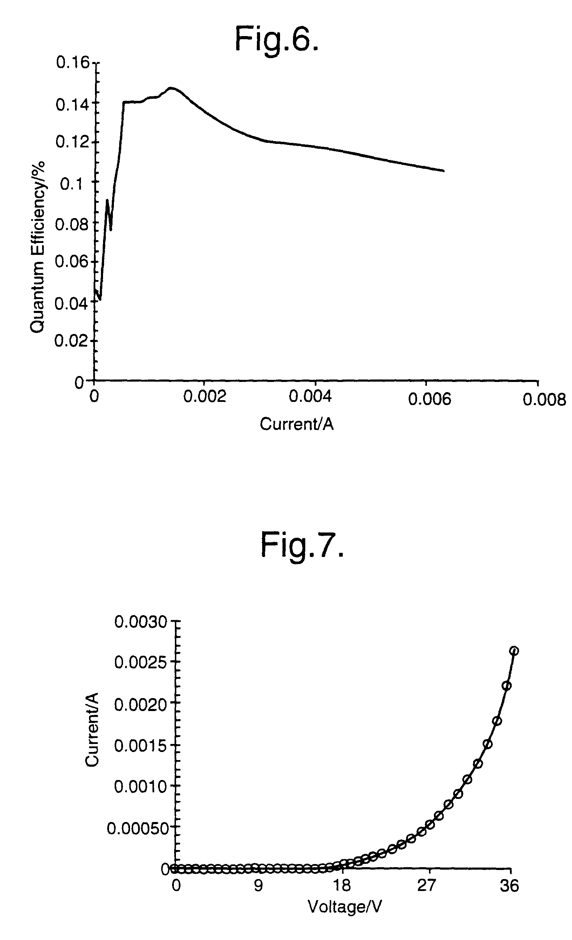

CN-PPV(1;R = OC₆H₁₃) was spin-coated (using a Dynapert photoresist spin-coater) from chloroform solution at 2000 rpm onto an ITO-coated glass substrate to give a layer of polymer of thickness approximately 300 nm. An aluminium contact of area approximately 10 mm² was deposited by vacuum evaporation on top of the polymer layer. Contacts were made to the ITO and to the aluminium electrode and a positive bias was applied to the ITO. For voltages above 30 V, red light was observed to be emitted from the device. The spectrum of the electroluminescence is shown in Figure 4. A typical current-voltage characteristic is shown in Figure 5. The variation of efficiency with current is shown in Figure 6. A maximum internal quantum efficiency of 0.3% was obtained. Brightnesses of over 10 cd/m² were obtained.

### Example 2

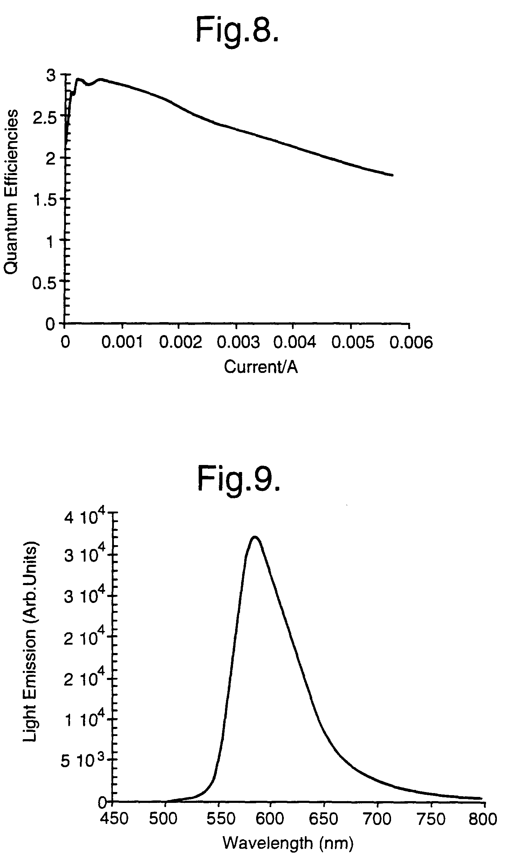

THT leaving group precursor to PPV (P.L. Burn, et al., J. Chem. Soc., Perkin Trans. 1., 1992, 3225-3231) was spin coated at 2000 rpm onto an ITO-coated glass substrate. The film was heated at 220°C for 12 hr to give a film of PPV thickness approximately 270 nm. CN-PPV (1;R = OC₆H₁₃) was then spin-coated on top of the PPV as described in Example 1. An aluminium contact of area approximately 10 mm² was deposited by vacuum evaporation on top of the polymer layer. Contacts were made to the ITO and to the aluminium electrode and a positive bias was applied to the ITO. For voltages above 15 V, red light was observed to be emitted from the device. The spectrum of the electroluminescence was similar to that obtained in Example 1. A typical current-voltage characteristic is shown in Fig. 7. The variation of efficiency with current of a typical device is shown in Fig. 8. Maximum internal quantum efficiencies of 3% were obtained. Brightnesses of over 150 cd/m² were obtained. A similar device using a calcium cathode had a maximum efficiency of 1.7%.

### Example 3

Devices were made using polymer (11) (as described in Example 2). Maximum quantum efficiencies of 2.5% were found. The emission spectrum is shown in Fig. 9.

### Example 4

Devices were made using the naphthalene polymer (as described in Example 2). Maximum quantum efficiencies of 2.0% were found. The emission spectrum is shown in Fig. 10.

### Example 5

Devices were made using polymer (28) (as described in Example 2). Maximum quantum efficiencies of 0.55% were found. The absorption and EL emission spectra (Fig. 11), the current and luminance versus voltage (Fig. 12) and the efficiency versus current (Fig. 13) for polymer (28) are shown.

### Example 6

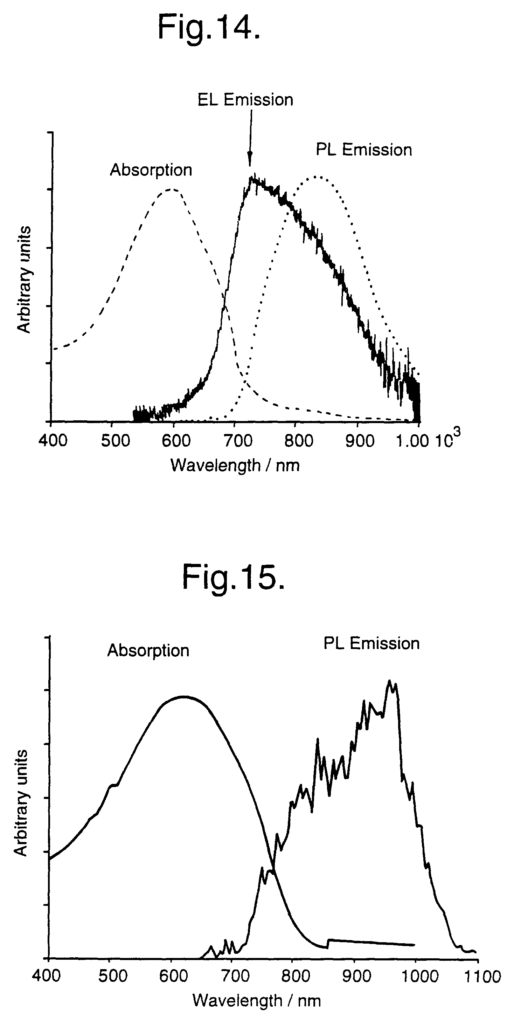

Devices were made using polymer (20) (as described in Example 2). Maximum quantum efficiencies of 0.2% were found. The absorption, PL and EL emission spectra (Fig. 15) are shown.

### Example 7

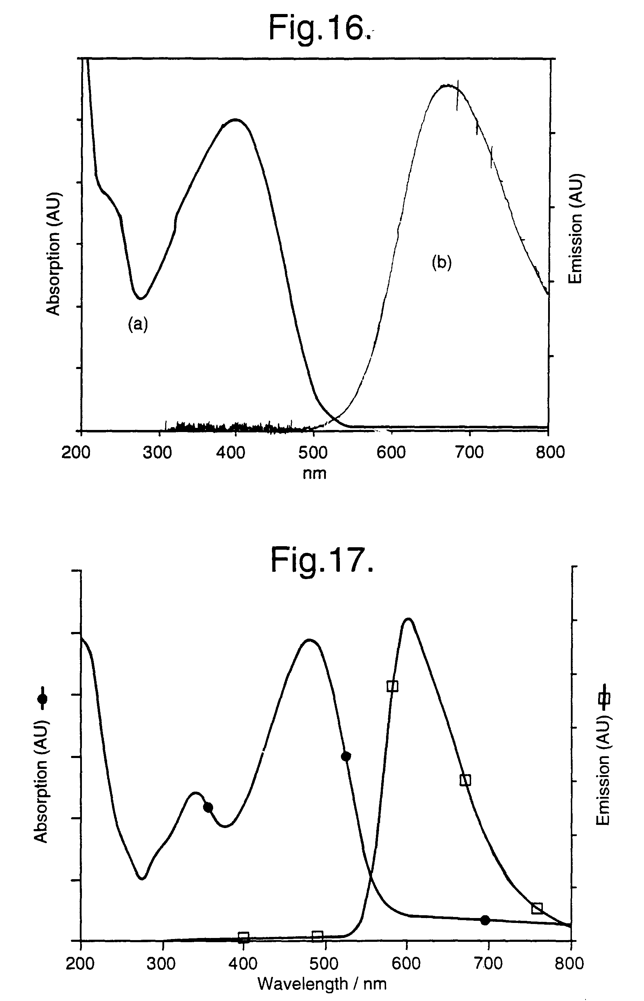

Devices were made in a similar way to those described in Example 2. A thin film of THT sulfonium precursor polymer to PPV was deposited on ITO and converted thermally to PPV (20nm) and then a solution of precursor polymer (36) was spun on top. After thermal conversion (240°C for 12 h) the thickness of the resulting second layer of polymer (37) was measured to be 80 nm. Calcium electrodes were evaporated on top as before. Maximum EL quantum efficiencies of 0.025% were obtained. The absorption and EL emission spectra of (37) are shown in Fig. 16.

### Example 8

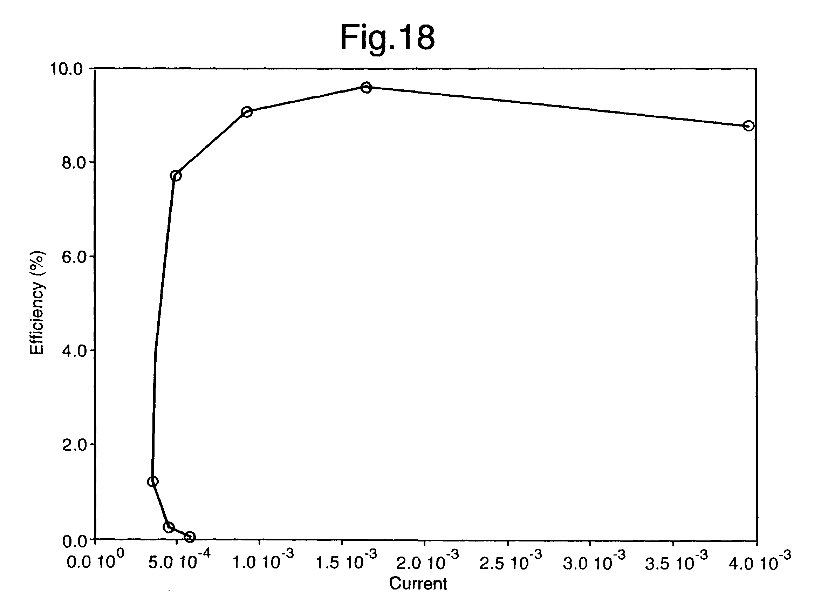

Devices were made using PPV (250 nm) and polymer (42) as the emissive layer (250 nm) as described in Example 2. Maximum EL quantum efficiencies of ca. 10% were measured. The absorption and emission spectra are shown in Fig. 17. A plot of efficiency versus current is shown in Fig. 18.

### Example 9

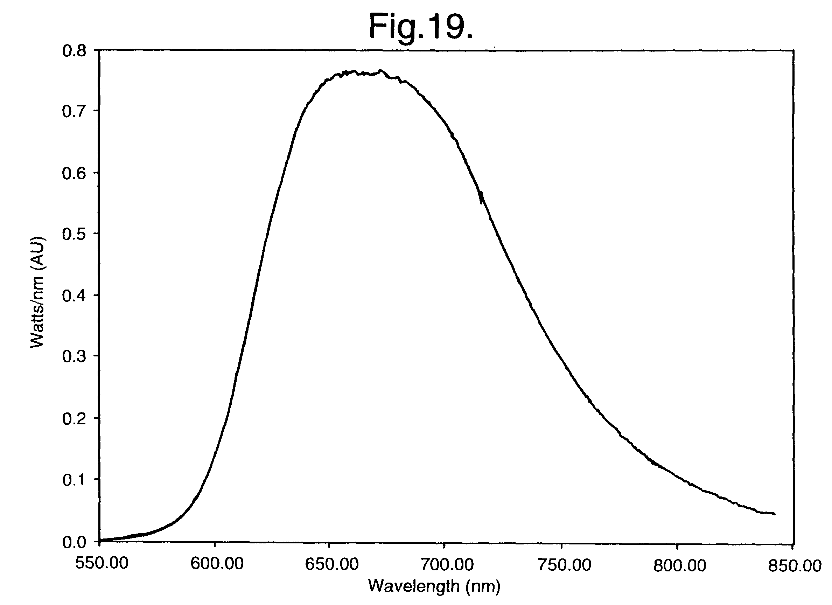

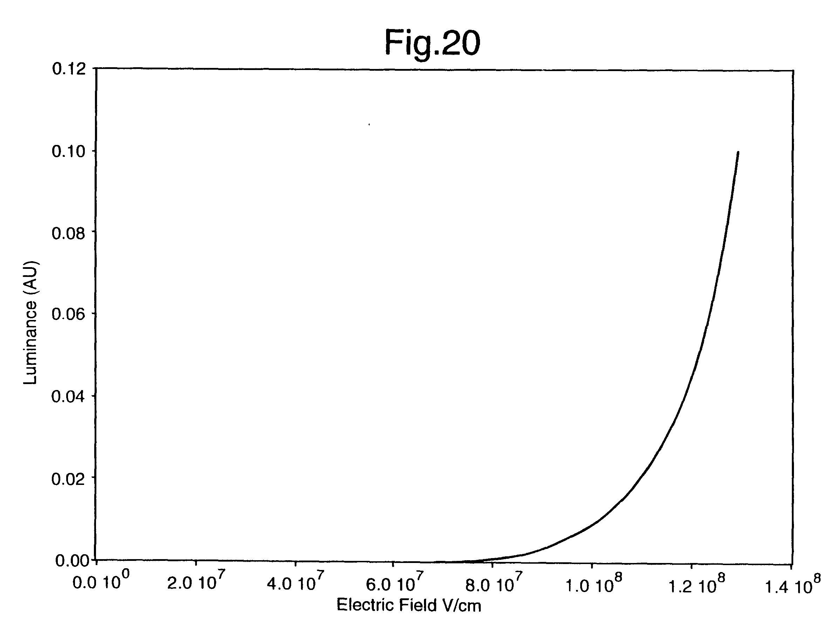

Devices were made by evaporating aluminium onto n-type silicon. A chloroform solution of CN-PPV (1) was spin-coated over the aluminium substrate. A methanol solution of THT sulfonium leaving group precursor to PPV was spin-coated over the polymer, and thermally converted into PPV by heating to 220°C in vacuum for 12 h. Semi-transparent ITO electrodes were RF-sputtered onto the PPV to form the positive contact. Maximum EL device efficiencies of 0.25% were found. The emission spectrum is shown in Fig. 19, and the variation in luminance with electric field is shown in Fig. 20.

### Exemplification 1

### Preparation of 1,4-dihexyloxy-2,5-benzenediacetonitrile (4)

A mixture of the dichloride (3) (9.55 g, 25.4 mmol), sodium cyanide (3 g, 52 mmol) in DMF (dry, 150 ml) was stirred at 60°C for 5h. Sodium hydroxide solution (0.1 M, 100 ml) was added to the cooled reaction mixture which was then extracted with ether (2 x 100 ml). The combined organic fractions were washed with water (2 x 50 ml), dried over MgSO₄, and the solvent was removed under reduced pressure. The resultant white solid was recrystallised twice from aqueous ethanol to yield (4) (7.42 g, 82%), m.p. 96-7°C, (Found C 74.2, H 9.3, N 7.5% C₂₂H₃₂N₂O₂ requires C 74.2, H 9.1, N 7.5%); IR (KBr) vₘₐₓ/cm⁻¹ 2344m, 1518s, 1427s, 1224s, 1032s, 870m, 757m, 724m; ¹H NMR (400.1 MHz, CDCl₃) 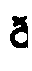 :0.89-1.7, (22 H, m, alkyl), 3.68 (4 H, s, CH2CN), 3.95 (4 H, t, J = 7 Hz, CH₂O), 6.69 (2 H, s, phenyl); ¹³C NMR. (100.6 MH_{z}, CDC1₃ 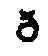 : 14.0, 18.6, 22.6c, 25.7, 29.2, 31.5, 68.9, 112.6, 117.9, 119.1, 150.0. m/z 356 (M, 20) , 272(12), 188 (100).

### Preparation of 1,4-dihexyloxy-2,5-bis(acetoxymethyl)benzene (5)

A solution of dichloride (3) (25.0 g, 67 mmol), anhydrous sodium acetate (16.0 g, 0.19 mol), and acetic anhydride (10 ml) in glacial acetic acid (140 ml) was heated to 90°C for 3h. The cooled reaction mixture was poured into water (250 ml) and the white precipitate was filtered, washed with water, and dried. It was recrystallised (aqueous ethanol) to give (5) (27.2g, 96%), m.p. 67-68 °C, (Found C 68.2, H 9.2%. C₂₄H₃₈O₆ requires C 68.2, 9.1%); IR (KBr) vₘₐₓ/cm⁻¹ 3065w, 1718s, 1519m, 1265s, 1215s, 1019m, 878m; ¹H NMR (400.1 MHz, CDC1³) 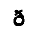 :0.9-1.8 (22 H, m, alkyl), 2.09 (6 H, s, CH₃CO), 3.92 (4H, t, J = 6 Hz), 5.13 (4 H, s, CH₂OAc), 6.87 (2 H, s, phenyl); ¹³C NMR (100.6 MHz, CDCl₃) 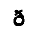 : 13.9, 20.9, 22.5, 25.7, 29.2, 31.5, 61.6, 68.9, 11:3.7, 125.1, 150.7, 170.8. m/z (EI) 422 (M, 90), 278 (20), 194 (55), 152 (100).

### Hydrolysis of the acetate (5)

A mixture of the diacetate (5) (22.0 g, 52 mmol) and sodium hydroxide (8.0 g) in ethanol (200ml) was stirred at room temperature. After 0.5 h the mixture cleared, but became cloudy after 1h, and was stirred for 1 further hour. It was poured into water (200 ml), and the precipitated solid was filtered, washed with water, and recrystallized (ethanol/water 80:20, 300 ml) to yield 1,4-dihexyloxy-2,5-benzenedimethanol (6) (15.1 g, 86%), m.p. 96-98°C, (Found C 70.9, H 10.0%. C₂₀H₃₄O₄ requires C 71.0, H 9.9%);IR (KBr) vₘₐₓ/cm⁻¹3310m, 1508m, 1205s, 1036s; ¹H NMR (400.1 MHz, CDCl₃) 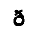 0.6-1.5 (22 H, m, alkyl), 3.63 (4 H, t, J = 6.5 Hz, CH₂0Ph), 4.33 (4 H, S, CH₂OH), 4.41 (2 H, s, OH), 6.64 (2 H, s, phenyl); ¹³C NMR (100.6 MHz, CDC1₃) 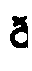 13.2, 22.1, 25.3, 28.9, 31.1, 59.0, 68.3, 111.0, 128.5, 149.6; m/z (EI) 338 (M, 70), 180 (30), 152 (75).

### Oxidation of the Diol (6)

A mixture of pyridinium chlorochromate (3.0 g, 14 mmol), diol (6) (2.0 g, 5.9 mmol) in dichloromethane (50 ml) was stirred for 8h. Water (100 ml) and ether (100 ml) were added and the mixture was stirred vigorously for 1h. The organic fraction was separated and the aqueous phase extracted with ether (100 ml). The combined organic fractions were washed with aqueous HC1 (1.0 mol/50 ml), water (2x 100 ml), dried (MgSO4), and the solvent removed in vacuo to leave a yellow solid. It was redissolved in dichloromethane and filtered through silica. The solvent was evaporated and the residue was recrystallized from hexane to yield 1,4-dihexyloxy-2,5-benzenedicarboxaldehyde (7) (1.85g, 94%), m.p. 74.5-76°C. (Found C 72.0, H 9.2%. C₂₀H₃₀O₄ requires C 71.8, H 9.1%);IR (KBr) vₘₐₓ/cm⁻¹ 1678s, 1421s, 1209s, 1131m. 993m, 689s; ¹H NMR (400 MHz, CDCl₃) 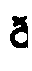 0.88-1.7 (22 H, m, alkyl), 4.07 (4 H, t, J = 7 Hz, CH₂O), 7.41 (2 H, s, phenyl), 10.50 (2 H, s, CHO); ¹³C NMR (100.6 MHz, CDCl₃) 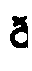 13.9, 22.5, 25.6, 28.9, 31.4, 69.1, 111.5, 129.1, 155.1, 189.3. m/z (EI) 334 (M, 18), 287 (10), 273 (100), 178 (63) 166 (80).

### Condensation Polymerisation of (4) and (7)

A mixture of the dialdehyde (7) (0.188 g, 0.56 mmol) and the dinitrile (5) (0.200 g, 0.56 mmol) was stirred in t-butanol (5 ml) and THF (5 ml) at 35°C under argon until the solution cleared. Potassium t-butoxide (15 mg) was added, and the stirring continued at 35°C for 1 h (a dark red solid formed after 30min.). The cooled mixture was poured into methanol (30 ml), and the solid filtered, washed with methanol, and dried. It was redissolved in chloroform (10 ml) and precipitated with ethyl acetate (40 ml). The red product was filtered and dried to yield (1, R=OC₆H₁₃) (0.137 g, 38%), m.p. 115-220°C, (Found C 75.9, H 8.9, N 3.9%. Polymer requires C 77.0, H 8.9, N 4.2%); ¹H NMR (250.1 MHz, CDC1₃) 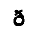 0.7-2.0 (22 H, m, alkyl), 4.09 (4 H, m, CH₂O), 7.16 (1 H, s), 7.93 (1 H, s), 8.10 (1H, s); IR (film) vₘₐₓ/cm⁻¹ 2211 w, 1214s, 1028s, 864m.

### Exemplification 2

### Bischloromethylation of 1-dodecyloxy-4-methylthio-2,5-benzene (9)

A mixture of the thioether (9) (2.75 g) and paraformaldehyde (3.0 g) was stirred in a mixture of hydrochloric acid (33%, 8 ml) and p-dioxan (25 ml) at 0°C while hydrogen chloride was bubbled through for 0.5 h. The temperature was raised to 80 °C and the mixture was vigorously stirred for 1 week. Ether (200 ml) was added to the cooled mixture which was then washed with water (3 x 200 ml), dried (Na₂SO₄), and evaporated to give an off-white solid. Recrystallisation from hexane yielded (9) m.p. 75-76°C; vₘₐₓ (KBr)/cm⁻¹ 1496s, 1471s, 1261s, 1180S; ¹H NMR (250.1 MHz, CDCl₃) 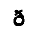 0.89 (3 H, t, J = 7 Hz, CH₃-CH₂), 1.27 (20 H, bs, alkyl), 1.84 (2 H, q, J = 7 Hz, CH₂CH₂-0), 2.46 3(H, s. SMe), 4.03 (2H, t, J = 6 Hz, CH₂-0), 4.62 and 4.78 (4 H, 2s, CH₂C1), 6.95 and 7.43 (2 H, 2s, Ar) ; 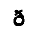 _{C}(100 MHz; CDC1₃) 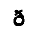 14.8, 18.7, 22.6, 26.0, 29.1, 29.3, 29.5, 29.6, 31.9, 40.8, 44.5, 68.6, 113.3, 127.2, 128.0, 139.3, 155.9.

### Synthesis of 1-dodecyloxy-4-methylthio-2,5-benzenediacetonitrile (10)

A mixture of the bis-chloromethyl compound (9) (3.4 g, 8.1 mmol) and sodium cyanide (0.98g, 20 mmol) in DMF (20 ml) was stirred at 50°C for 3 h. The cooled mixture was poured into water (100 ml) and extracted with ethyl acetate (2 x 100 ml). The combined organic fractions were reduced in vacuo to leave a yellow oil. Hexane (50 ml) was added, and a creamy solid precipitated. The solid was filtered, washed with hexane and dried to yield (10) (0.81 g, 35%), m.p. 100-2°C, (Found M⁺ 386.2399. C₂₃H₃₄N₂OS requires M 386.2393); ¹H NMR (250.1 MHz, CDCl₃) 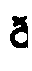 0.9-1.9 (23 H, m, alkyl), 2.42 (3 H, s, SMe), 3.66 and 3.93 (4 H, 2s, CH2CN), 4.01 (2 H, t, J 7, CH20), 6.97 and 7.41 (2 H, 2s, phenyl). ¹³C NMR (62.9 MHz, CDCl₃) 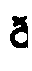 14.1, 18.4, 18.6, 22.4, 22.7, 26.0, 29.0, 29.1, 29.4, 29.60, 29.61, 29.65, 31.9, 68.8, 111.8, 117.5, 117.7, 119.8, 127.5, 131.7, 132.2, 155.5; IR (KBr) vₘₐₓ/cm⁻¹ 2245m, 1394s, 1252s, 1172m, 1148m. m/z 386 (M, 25%), 218 (100).

### Polymerization of (10) and (7)

A mixture of the dinitrile (10) (0.10 g. 0.26 mmol) and the dialdehyde (7) (86 mg, 0.26 mmol) was stirred in t-butanol (10 ml) at 50°C. Potassium t-butoxide (0.01 g) was added and the stirring was continued for 1 h at the same temperature, whereupon an orange solid precipitated out. Methanol (50 ml) was added to the cooled mixture, and the solid was filtered, washed with methanol, and dried. It was redissolved in dichloromethane (10 ml) and precipitated with the addition of ethyl acetate (30 ml). The solid was filtered, washed with ethyl acetate and dried to give an orange solid (11) (124 mg, 71%), ¹H NMR (250.1 MHz, CDC1₃) 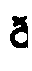 : 0.7-1.8 (45 H, m, alkyl), 2.51 (3 H, s, SMe), 4.12 (6 H, bs, OCH₂), 7.02, 7.54, 7.79, 7.93, 7.97, 8.03 (6 H, 6s, aromatic); IR (KBr) vₘₐₓ/cm⁻¹ 2206m, 1427s, 1217s, 1027m.

### Exemplification 3

### 2,6-Dihexvloxy-naphthalene (12)

A solution of sodium (3.04 g, 132 mmol) in dry methanol (60 ml) was refluxed for 30 minutes and cooled. A solution of 2,6-naphthalenediol (9.0 g, 56.2 mmol) in dry methanol (40 ml) was added and the mixture refluxed for 30 minutes and cooled. 1-Bromohexane (17.5 ml, 125 mmol) was added and the reaction mixture was refluxed under an argon atmosphere for 19 h. The solvent was evaporated and ether (250 ml) was added. It was washed with aqueous sodium hydroxide solution (10%, 100 ml) and water (2 x 100 ml) to yield a dark brown solution. After refluxing with activated charcoal for 30 min and filtration, the solution was evaporated to yield an oil which was recrystallised from methanol (250 ml). The fine white platelets were collected at the pump and washed with a little cold methanol to give (12) (8.33 g). A recrystallisation gave more product (0.67 g, 49% total yield), m.p. 78.0 - 79.0°C, R_{f} 0.83 (dichloromethane), (Found: C, 80.7; H, 10.0; M⁺, 328.2404. C₂₂H₃₂0₂ requires C, 80.4; H, 9.8; M, 328.2404); vₘₐₓ (KBr)/cm⁻¹ 3050w, 2900s, 2840s, 1590s, 1495m, 1455m, 1385s, 1375(s), 1225s, 1165s, 1110s, 1070s, 1045s, 995s, 965s, 850s; ¹HNMR (400 MHz; CDCl₃) 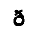 0.93 (6H, t, J = 6.8 Hz, -CH₃), 1.42-1.32 (8H, m, alkyl), 1.50 (4H, qn, J = 7.3 Hz, OC₂H₄-CH₂), 1.84 (4H, qn, J = 7.1 Hz, ArOCH₂-CH₂), 4.04 (4H, t, J= 6.6 Hz, O-CH₂), 7.09 (2H, d, J = 2.1 Hz Ar_{1,5}-H), 7.13 (2H, dd, J = 8.8 Hz, 2.2, Ar_{3,7}-H), 7.62 (2H, d, J = 8.9 Hz, Ar_{4,8}-H); 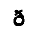 _{C}(100 MHz; CDCl₃) 14.1, 22.6, 25.8, 29.3, 31.6, 68.0, 106.9, 119.2, 128.0, 129.7, 155.5; m/z (EI) : 328 (M, 16%), 244 (13,M-C₆H₁₂), 160 (100,M-2C₆H₁₂), 131 (21), 55 (21).

### 1,5-Bis(methoxymethyl)-2,6-dihexyloxy-naphthalene (13)

Hydrogen chloride was bubbled through a stirred solution of formaldehyde (37% w/w; 25 ml, 270 mmol) and hydrochloric acid (37% w/w, 25 ml, 270 mmol) for 15 minutes. A solution of 2,6-dihexyloxynaphthalene (8.95 g, 27.2 mmol) in 1,4-dioxane (140 ml) was added dropwise over 15 minutes with the gas flow continuing. A white precipitate appeared just before the end of the addition after 30 minutes. The gas was bubbled through for a further 90 minutes and the reaction stirred for 14 hours longer. The reaction mixture was filtered and the precipitate washed with water until the washings were no longer acidic (5 x 100 ml) (crude yield 22.5 g). The crude product was stirred in warm methanol (250 ml), the crystals collected at the pump and washed with some ice-cold methanol to yield fine white crystals of (13) (8.64 g, 81% yield). m.p. 103.0 - 103.5°C, R_{f}0.37 (dichloromethane), (Found: C, 75.04; H, 9.79; M⁺ 416.2927. C₂₆H₄₀0₄ requires C, 74.96; H, 9.68 %; M, 416.2927); vₘₐₓ(KBr)/cm⁻¹ 1595(m), 1265(s), 1245(s), 1190(m), 1180(m), 1100(s), 1080(s), 935(m), 925(m), 805(m); 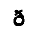 _{H}(250 MHz; CDCl₃) 0.91 (6H, t, J = 7.0 Hz, -CH₃), 1.42-1.32 (8H, m, alkyl, 1.56-1.45 (4H, m, ArOC₂H₄-CH₂), 1.82 (4H, qn, J = 5.6 Hz, OCH₂-CH₂), 3.39 (6H, S, O-CH₃), 4.08 (4H, t, J = 6.5 Hz, ArO-CH₂-), 4.97 (4H, s, Ar-CH₂-), 7.28 (2H, d, J = 9.3 Hz, ArH_{4,8}), 8.07 (2H, d, J = 9.3 Hz, ArH_{3,7}); 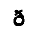 _{C} (63 MHz; CDCl₃) 13.8, 22.4, 25.6, 29.4, 31.4, 57.4, 64.3, 69.7, 115.6, 118.9, 125.8, 129.3, 153.4; m/z (EI): 416 (M⁺, 55%), 300 (17, M⁺-CH₃OC₆H₁₃), 243 (30), 226 (12), 199 (90, M⁺-CH₃OC₆H₁₃,OC₆H₁₃), 184 (56,M⁺-2CH₃OC₆H₁₃), 165 (100), 139 (12), 123 (10), 105 (13).

### 1,5-Bis(iodomethyl)-2,6-dihexyloxy-naphthalene

A mixture of the bismethoxy compound (12) (1.00 g, 2.40 mmol) and sodium iodide (719 mg, 4.80 mmol) in acetonitrile (19 ml) was stirred at 0°C. Boron trifluoride etherate (590 1, 4.80 mmol) was slowly added at this temperature and the reaction was left to stir for 24 hours at room temperature. Ethyl acetate (100 ml) was added and the crystals collected at the pump and washed with a little ice-cold solvent and dried in vacuo to yield yellow crystals (915 mg, 63%), m.p. 121.0 - 121.5°C, R_{f} 0.85 (dichloromethane), (Found: C, 47.5; H, 5.6. C₂₄H₃₄O₂I₂ requires C. 47.4; H, 5.6 %); vₘₐₓ(KBr)/cm⁻¹ 3030w, 1580m, 1250s, 1180s, 1180s, 1140s, 1115s, 1110s, 1075s, 1045s, 800s, 705m; 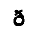 _{H}(250 MHz; CDCl₃) 7.93 (2H, d, J = 9.3 Hz, ArH_{3,7}), 7.30 (2H, d, J = 9.3 Hz, ArH_{4,8}), 4.94 (4H, s, CH₂-I), 4.17 (4H, t, J = 6.4 Hz, O-CH₂), 1.88 (4H, qn, J = 6.9 Hz, OCH₂-CH₂-), 1.59-1.50 and 1.43-1.35 (6H, br m, alkyl), 0.92 (6H, t, J = 7.0 Hz, CH₂CH₃); 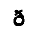 _{C}(100 MHz; CDC1₃) 152.6, 127.4, 124.7, 120.0, 115.0, 69.1, 57.4, 31.6, 29.6, 25.8, 22.6, 14.1, -1.3.

### Preparation of 2,6-dihexyloxy-1,5-naphthalenediacetonitrile (14)

A mixture of 1,5-bis(iodomethyl)-2,6-dihexyloxy-naphthalene (0.50 g, 0.83 mmol) and sodium cyanide (0.16 g, 1.74 mmol) was stirred in DMF (50 ml) at 55°C for 1 h. Water (50 ml) was added to the cooled mixture and the resulting precipitate was filtered, washed with water and dried. It was redissolved in a minimum of dichloromethane, hexane (40 ml) was added, and the solution was cooled to -4°C overnight. The product was filtered to yield (14) (0.21 g, 63%), m.p. 135-6°C; ¹H NMR (250.1 MHz, CDC1₃) 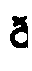 0.9-1.9 (22 H, m, alkyl), 4.11 (4 H, s, CH₂CN), 4.14 (3 H, t, J = 7 Hz, CH₂0), 7.35 and 7.88 (2 H, 2d, J- 10 Hz, aromatic); ¹³C NMR. (62.9 Mhz, CDC1₃) 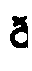 13.5, 14.2, 22.8, 25.9, 29.6, 31.7, 69.8, 112.2, 115.8, 118.3, 121.5, 127.9, 152.9; IR (KBr) vₘₐₓ/cm⁻¹ 2248w, 1598s, 1261s, 1067s, 802m. m/z 406 (M, 28), 238 (100), 91 (95).

### Condensation Polymerisation of (14) and (7)

A solution of the dinitrile (14) (0.12 g, 0.295 mmol) and the dialdehyde (7) (98 mg, 0.295 mmol) in t-butanol (15 ml) was stirred at 50°C when potassium t-butoxide (10 mg) was added. Stirring was continued for 1.5 h at the same temperature, when a further 10 mg of base was added. After a total of 4 h at 60°C, methanol was added to the cooled red solution, and the yellow precipitate was filtered, washed with methanol, and dried to yield a yellow solid (15) (82 mg, 39%), ¹H NMR (250.1 MHz, CDCl₃) 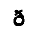 : 0.6-2.8 (m, alkyl), 4.13 (bs, CH₂0), 6.2-8.1 (m, aromatic); IR (KBr) vₘₐₓ/cm⁻¹ 2207m, 1587m, 1423m, 1209m, 813m.

### Exemplification 4

### Preparation of 1,8-bis-(4-formyl(phenoxy)octane (15)

A mixture of 1,8-dibromooctane (8.0 g, 29.5 mmol), p-hydroxy-benzaldehyde (7.2 g, 59 mmol) and potassium carbonate (8.2 g, 6.0 mmol) in DMF (50 ml) was heated to 55 C with stirring for 8 h. The cooled solution was poured into water and the precipitate was filtered, washed with water, and dried. Recrystallisation from hot ethanol (200 ml) yielded (15) (7.72 g, 73%), m.p. 89°C-91°C, (Found C 74.4, H 7.4 %. C₂₂H₂₆O₄ requires C 74.5, H 7.4 %), ¹H NMR (250.1 MHz, CDC1₃) 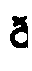 : 1.3-1.9(12 H, m, alkyl), 4.02(4 H, t, J = 7 Hz, CH₂O), 6.97 and 7.81 (8 H, 2d, J = 11 Hz, aromatic), 9.85 (2 H, s, CHO); IR (KBr) vₘₐₓ/cm⁻¹ 1698s, 1598s, 1156s, 834s. m/z 354 (M, 45), 326 (30), 233 (15), 121 (55), 69 (100).

### Exemplification 5

### Preparation of Polymer (20)

A solution of the dinitrile (18) (0.138 g, 0.448 mmol) and the dialdehyde (7) (0.159 mg, 0.448 mmol) in t-butanol (12 ml) was stirred at 60°C when potassium t-butoxide (20 mg) was added. Stirring was continued for 0.5 h at the same temperature, when a dark solid precipitated out. Methanol (100 ml) was added to the cooled solution, and the violet precipitate was filtered, and dried. It was redissolved in a minimum of chloroform (ca. 5 ml) and reprecipitated with methanol (60 ml) to give (20) (91 mg, 33%), ¹H NMR (250.1 MHz, CDCl₃) 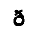 ; 0.8-2.0 (m, alkyl), 2.78 and 3.0 (2t, 4.13 (bs, CH₂-thiophene), 4.10 (m, CH₂0), 6.9-9.2 (m, aromatic); IR (KBr) vₘₐₓ/cm⁻¹ 2206m, 1216s, 1026m, 856m.

### Exemplification 6

### 1-Chloromethyl-2,5-dihexyloxy-4-benzenemethanol (31)

A mixture of the diol (6)(8.2 g, 24.3 mmol), hexane (60 ml), petroleum ether ((60/40), 20 ml)) and conc HC1 (150 ml) was heated to 60-65°C while stirring vigorously. As soon as all the solid dissolved the reaction was cooled, and hexane (100 ml) was added. The organic fraction was separated, washed with water (2 x 100 ml), dried (Na₂SO₄) and concentrated in vacuo. The oil was dissolved in hexane (50 ml) and cooled to -4°C, whereupon a white solid crystallised out. The solid was filtered, and recrystallised from hexane in an analogous fashion to yield (31) as a white solid (2.3 g, 26%), vₘₐₓ (KBr)/ cm⁻¹ 3325m, 1510s 1420s, 1213s, 1034s, 1000s, 747m, 668m; 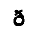 _{H} (250.1 MHz; CDCl₃) 0.9-1.9 (22H, m), 2.2 (1H, bs), 3.96 (6H, t J =7), 4.62 (2 H, s), 4.63 (2 H, s), 6.85 (1 H, s), 6.87 (1 H, s); 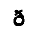 _{C} (62.9 MHz; CDCl₃) 14.2, 22.7, 25.9, 29.5, 31.7, 41.7, 62.1, 68.9, 69.4, 113.1, 113.8, 125.7, 130.7, 150.6, 150.9, m/z (CI) 356(M⁺, 10), 339 (55), 321 (100), 305 (40) [exact mass (M⁺; CI) 356.211, C₂₀H₃₃O₃Cl requires 356.211].

### 2,5-Dihexyloxy-4-(hydroxymethyl)-benzeneacetonitrile (32)

A solution of the chloride (31)(1.52 g) and sodium cyanide (0.22 g) in DMF (50 ml) was stirred at 60°C for 3h. It was poured into water (100ml), and extracted with ether -hexane (1:1, 150 ml). The organic fraction was washed with water, dried (MgSO₄) and the solvent evaporated to give an oil, which was crystallised from hexane (80 ml) to give (32), (1.31 g, 88%), as needles, m.p. 63-66°C, [Found C 73.0, H 9.7, N 3.8. C₂₁H₃₃NO₃ requires C 72.6, H 9.6, N 4.0 %]; vₘₐₓ (KBr)/ cm⁻¹ 3334m, 2250m, 1511s, 1425s, 1395s, 1216s, 1192s, 1034s, 998s, 871m, 724m; 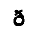 _{H} (250.1 MHZ; CDCl₃) 0.9-1.9 (22H, m), 4.36 (4H, m), 2.42 (1H, t, J = 5), 3.68 (2 H, s), 4.66 (2 H, d, J = 5), 6.84 (1H, s), 6.89 (1H, s); 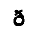 C (62.9 MHz; CDCl₃) 14.1, 18.7, 22.7, 25.9, 29.4, 31.7, 62.0, 69.1, 112.4, 112.7, 118.3, 130.2, 150.2, 150.7, m/z (CI) 347 (M⁺, 43), 330 (100), 263 (5).

### 2,5-Dihexyloxy-3-formylbenzeneacetonitrile (33)

A mixture of the alcohol (32) (1.15 g) and pyridinium chlorochromate (PCC) (0.75 g) in dichloromethane was stirred for 2h. A further portion of PCC (0.5 g) was added and stirring continued for 1h. The mixture was poured into water and extracted with ether (120 ml). The organic fraction was washed with water, and the solvent removed in vacuo to give an oil. Chromatography on silica followed by two recrystallisations from hexane gave (33) as a white solid, vₘₐₓ (KBr)/ cm⁻¹ 2245w, 1677s, 1614m, 1500s, 1428s, 1390s, 1204s, 1069m, 693m. 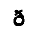 _{H} (250.1 MHz; CDC1₃) 0.9-1.9 (22H, m), 3.73, (2 H, 2), 3.98 (2H, t, J = 7), 4.06 (2H, t, J = 7), 6.97 (1H, s), 7.27 (1H, s); 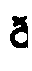 C (62.9 MHz; CDCl₃) 14.1, 19.5, 22.7, 25.8, 29.2, 31.6, 69.0, 69.6, 109.2, 114.3, 117.4, 125.0, 127.1, 150.2, 156.2, 189.2; m/z (CI) 346 (M⁺, 40), 238 (100). [Exact mass (M⁺; CI) 346.238, C₂₁H₃₂O₃N requires 346.238].

The following general procedure for the preparation of polymers 20 to 30 is based on the methods described in the preceding exemplifications.

An equimolar mixture of the aryldialdehyde (ca. 100mg) and the aryldiacetonitrile was dissolved in a mixture of t-butanol (2 ml) and tetrahydrofuran (2 ml). The reaction mixture was stirred and heated to 50°C and tetra-n-butylammonium hydroxide (5 wt %) and potassium t-butoxide (5 wt %) was added. The reaction mixture was stirred for between 15 min to 2 h, then it was cooled and poured into methanol containing acetic acid. The precipitate was filtered, washed with methanol, dissolved in chloroform, and the product was reprecipitated from methanol. The polymer was then isolated by filtration and was dried in vacuo. Yields averaged 50-70%. Number average molecular weights ranged from 1110 to 10,200. The number average molecular weights, UV/VIS absorption maxima and optical band gap of each polymer are summarised in the following Tables 1 and 2. The molecular weight values in brackets refer to values determined initially and which have been improved upon repetition of the preparation of the polymers.

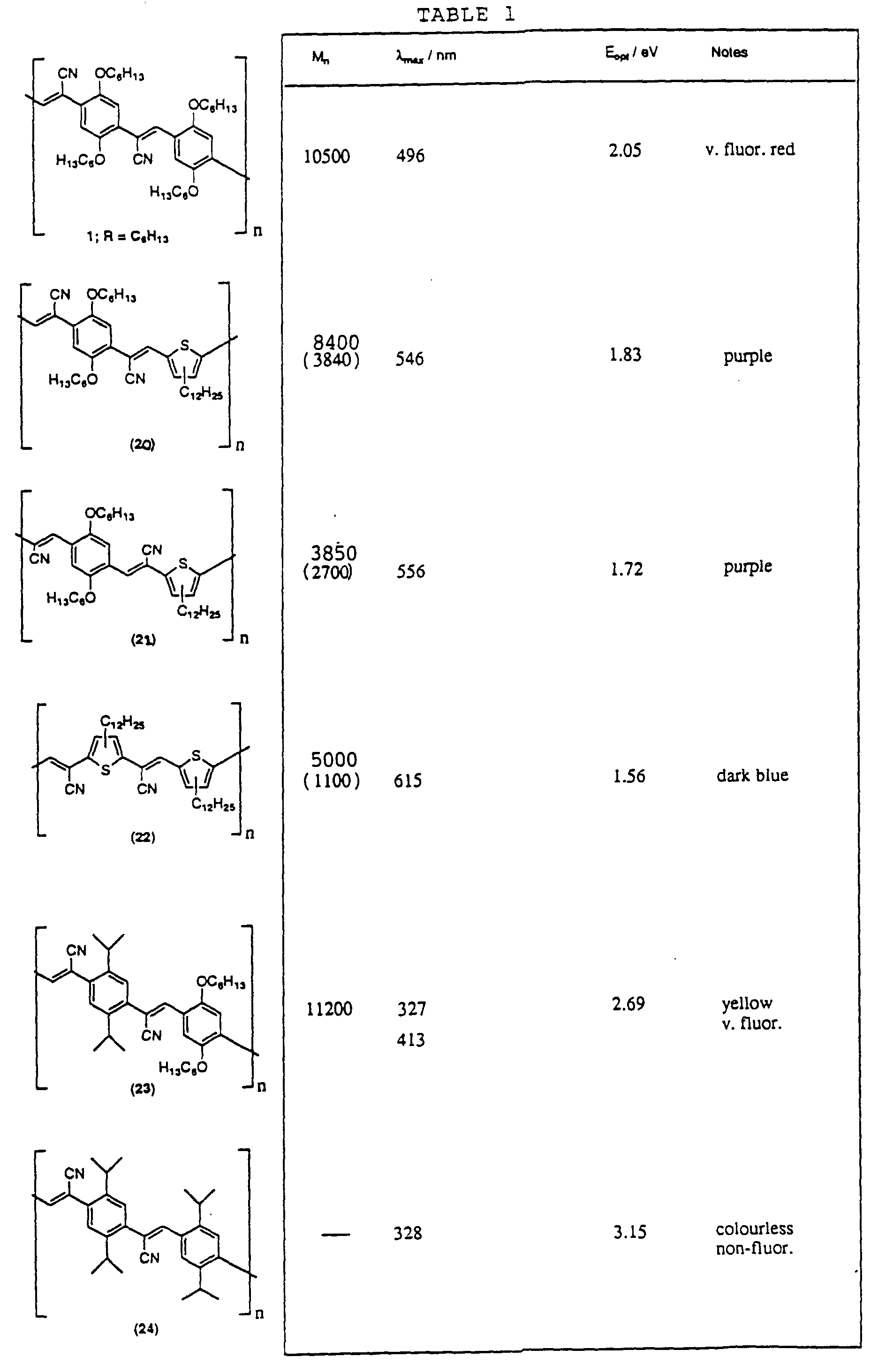

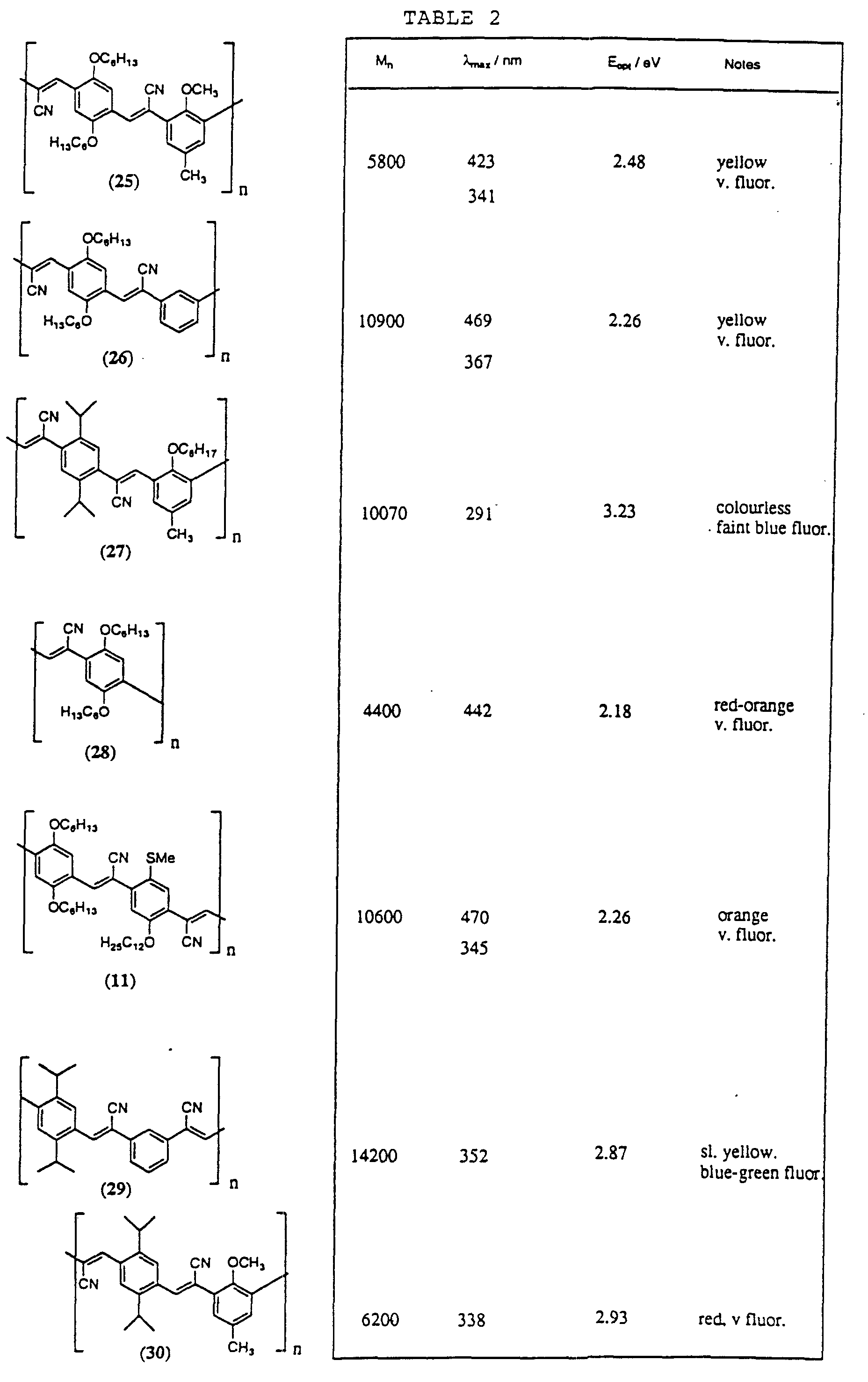

## Claims

1. A semiconductive conjugated polymer comprising arylene vinylene units forming at least part of the polymer main chain in which a solubilising group is present on at least some of the arylene moieties so as to render the polymer solution processible in either a polar solvent or a non-polar solvent with the proviso that if the solubilising group is alkoxy, it has more than 4 carbon atoms, and an electron-withdrawing group is conjugatively linked to at least some of the vinylene moieties, wherein the solubilising group and the electron-withdrawing group are selected so that the polymer emits radiation when excited to luminesce.

2. A semiconductive conjugated polymer according to claim 1, wherein the electron-withdrawing group is selected to modulate the optical properties of the polymer.

3. A semiconductive conjugated polymer according to claim 2, wherein the electron-withdrawing group is selected to modulate the wavelength of radiation emitted in electroluminescence.

4. A semiconductive conjugated polymer according to any one of the preceding claims, wherein the electron-withdrawing group comprises a nitrile group, an ester group, an acid amide, a sulfone, a sulfoxide, a trifluoromethyl, a phosphinoyl, a phosphonate or a ketone group.

5. A semiconductive conjugated polymer according to any one of the preceding claims, wherein the solubilising group comprises an alkoxy or alkyl group with more than 4 carbon atoms.

6. A semiconductive conjugated polymer according to any one of the preceding claims, wherein the polymer comprises at least some regions of
-Ar-CX = RC-Ar'-CR = CX-
in which Ar and Ar' are the same or different and represent arylene moieties or arylene-containing moieties, at least some of which are substituted with a solubilising group, X is an electron-withdrawing group and R is alkyl, aryl or hydrogen.

7. A semiconductive conjugated polymer according to any one of the preceding claims, which is substantially fully conjugated and has the following general formula: 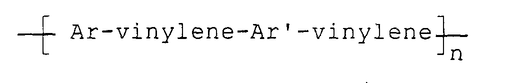 in which Ar and Ar' are the same or different and represent arylene groups, each vinylene is substituted with the electron withdrawing group X, and n represents the degree of polymerisation.

8. A semiconductive conjugated polymer according to any one of the preceding claims, having the general formula:

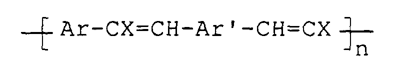

9. A semiconductive conjugated polymer according to claim 8, wherein Ar and Ar' are both 2,5-dihexyloxy-',⁴-phenylene moieties and X is CN.

10. A semiconductive conjugated polymer according to claim 8, wherein Ar is 2-dodecyloxy,5-methylthio-1,4-phenylene, Ar' is 2,5-dihexyloxy-1,4-phenylene, and X is CN.

11. A semniconductive conjugated polymer according to claim 8, wherein Ar is 2,6-dihexyloxy-1,5-naphthalene, Ar' is 2,5-dihexyloxy-1,4-phenylene, and X is CN.

12. A semiconductive conjugated polymer according to claim 8, wherein Ar is a 2,5-dihexyloxy-1,4-phenylene, Ar' is a 3-dodecyl-substiruted-2,5-thiophene, and X is CN.

13. A semiconductive conjugated polymer according to claim 8, wherein Ar is a 3-dodecyl-substituted-2,5-thiophene, Ar' is a 2,5 dihexyloxy-1,4-phenylene, and X is CN.

14. A semiconductive conjugated polymer according to claim 8, wherein Ar is a 2,5-diisopropyl-1,4-phenylene, Ar' is a 2,5-dihexyloxy-1,4-phenylene, and X is CN.

15. A semiconductive conjugated polymer according to claim 8, wherein Ar is a 2-methoxy-5-methyl-1,3-phenylene, Ar' is a 2,5-dihexyloxy-1,4-phenylene, and X is CN.

16. A semiconductive conjugated polymer according to claim 8, wherein Ar is a 1,3-linked-phenylene, Ar' is a 2,5-dihexyloxy-1,4-phenylene, and X is CN.

17. A semiconductive conjugated polymer according to claim 8, wherein Ar is a 2,5-diisopropyl-1,4-phenylene, Ar' is a 2-octyloxy-5 methyl-1,3-phenylene, and X is CN.

18. A semiconductive conjugated polymer according to claim 8, wherein Ar is a 2-methylthio, 5-dodecyloxy-1,4-phenylene, Ar' is a 2,5-dihexyloxy-1,4-phenylene, and X is CN.

19. A semiconductive conjugated polymer according to claim 8, wherein Ar is all, 3-linked phenylene, Ar' is a 2,5-diisopropyl-1,4-phenylene, and X is CN.

20. A semiconductive conjugated polymer according to claim 8, wherein Ar is a 2-methoxy-5-methyl-1,3-phenylene, Ar' is a 2,5-diisopropyl-1,4-phenylene, and X is CN.

21. A semiconductive conjugated polymer according to claim 8, wherein Ar and Ar' are both 3-dodecyl-2,5-thiophene, and X is CN.

22. A semiconductive conjugated polymer according to claim 8, wherein Ar and Ar' are both 2,5-diisopropyl-1,4-phenylene, and X is CN.

23. A semiconductive conjugated polymer according to claim 8, wherein Ar and Ar' are both 2-methoxy-5-(2'-ethylhexyloxy)-1,4-phenylene, and X is CN.

24. A semiconductive conjugated polymer according to claim 7, which comprises poly(2,5 hexyloxy cyanoterephthalylidene)

25. A semiconductive conjugated polymer according to any one of claims 1 to 5, which comprises unconjugated regions and conjugated regions incorporating the arylene vinylene units.

26. A semiconductive conjugated polymer according to claim 25, wherein the conjugated regions comprise distyrylbenzene moieties which incorporate the arylene vinylene units.

27. A semiconductive conjugated polymer according to claim 26, having the following general formula: 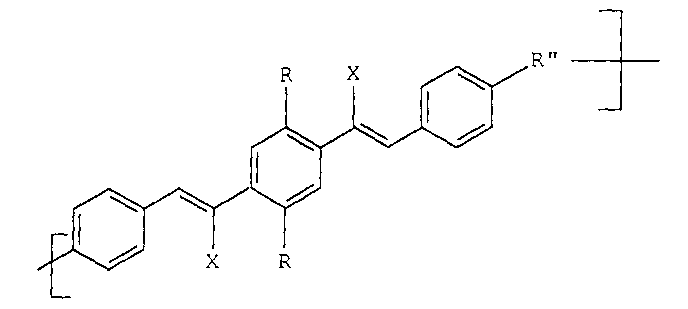 in which at least one of R and R' is a solubilising group,X is the electron-withdrawing group, and R" is an aliphatic linker group.

28. A semiconductive conjugated polymer according to claim 27, wherein R and R' are both hexyloxy groups, X is CN and R" is -O-(CH₂)₈-O-.

29. A method of making a semiconductive conjugated polymer according to claim 1, which method comprises reacting a first compound of general formula
X-CH₂-Ar-CH₂-X
with a second compound of general formula
O=(R)C-Ar'-C(R)=O
under conditions to produce a polymer comprising at least some regions of
-Ar-CX = RC-Ar'-CR = CX-
in which Ar and Ar' are the same or different and represent arylene moieties or arylene-containing moieties, at least some of which are substituted with a solubilising group, X is an electron-withdrawing group and R is alkyl, aryl or hydrogen.

30. A method according to claim 29, wherein the reaction is performed under base catalysis.

31. A method according to claim 30, wherein the base comprises potassium t-butoxide, tetra-N-butylammonium hydroxide or mixtures thereof.

32. A method according to any one of claims 29 to 31, which is performed in the presence of t-butyl alcohol, and/or THF as solvent components.

33. A method according to any one of claims 29 to 32, which is performed in the temperature range 20 to 60°C.

34. A method according to any one of claims 29 to 33, wherein R is hydrogen.

35. A method according to any one of claims 29 to 34, wherein X comprises a nitrile group, an ester group, an acid amide, a sulfone, a sulfoxide, a trifluoromethyl, a phosphinoyl, a phosphonate or a ketone group.

36. A method according to any one of claims 29 to 35, wherein the solubilising group comprises an alkoxy or alkyl group with 4 or more carbon atoms.

37. A method according to any one of claims 29 to 36, wherein Ar and Ar' are as defined in any one of claims 9 to 24, and X is CN.

38. A method according to any one of claims 29 to 36, wherein Ar' comprises the unit Ar"-R"-Ar"' in which Ar" and Ar"' are the same or different and represent arylene moieties, and R" represents an aliphatic linker group.

39. A method according to claim 38, wherein Ar" and Ar"' are both p phenylene, X is CN and R" is -O-(CH₂)₈-O-.

40. An optical device which comprises a first contact layer, and a semiconductive layer in contact with the first contact layer, wherein the semiconductive layer comprises an emissive layer of a semiconductive conjugated polymer comprising arylene vinylene units forming at least part of the polymer main chain, a solubilising group is present on at least some of the arylene moieties so as to render the polymer solution processible in either a polar solvent or a non-polar solvent, with the proviso that if the solubilising group is alkoxy, it has more than 4 carbon atoms, and an electron-withdrawing group is conjugatively linked to at least some of the vinylene moieties so that the polymer emits radiation when excited to luminesce.

41. An optical device according to claim 40, wherein the semiconductive conjugated polymer is as defined in any one of claims 2 to 28.

42. An optical device according to claim 40, wherein the semiconductive conjugated polymer is obtainable by a method according to any one of claims 29 to 39.

43. An optical device according to any one of claims 40 to 42, comprising a photoluminescent device in which the polymer is excited to luminesce upon application of radiation thereto.

44. An optical device according to any one of claims 40 to 42, comprising an electroluminescent device wherein the first contact layer is in contact with a first surface of the semiconductive layer, and a second contact layer is in contact with a second surface of the semiconductive layer, so that the polymer emits radiation upon application of an electric field between the first and second contact layers.

45. An optical device according to claim 44, wherein the semiconductive layer further comprises a hole-transporting polymer layer between the emissive layer and the first contact layer, which hole-transporting polymer layer matches the first contact layer for hole injection.

46. An optical device according to claim 45, wherein the first contact layer comprises indium-tin oxide and the hole transporting polymer comprises poly(paraphenylenevinylene) polythiophene or polyphenylene.

47. An optical device according to any one of claims 44 to 46, wherein the second contact layer comprises a metal selected from aluminium and gold.

48. An optical device according to claim 47, wherein the second contact layer comprises aluminium.

49. An optical device according to any one of claims 44 to 48, wherein the second contact layer is also in contact with a substrate.

50. An optical device according to claim 49, wherein the substrate comprises silicon or germanium.

51. A method of making an optical device according to claim 49 or claim 50, which method comprises:
(a) providing the second contact layer in contact with the substrate;
(b) forming a layer of the semiconductive conjugated polymer on the second contact layer;
(c) forming a layer of the hole-transporting polymer on the layer of the semiconductive conjugated polymer; and
(d) forming the first contact layer on the layer of the hole-transporting polymer.

52. A method according to claim 51, wherein the second contact layer is evaporated onto the substrate in step (a).

53. A method according to claim 51 or claim 52, wherein the semiconductive conjugated polymer is formed in step (b) from solution.

54. A method according to any one of claims 51 to 53, wherein the hole-transporting polymer is applied in step (c) in soluble precursor form which is subsequently thermally converted to form the hole-transporting polymer.

55. A method according to any one of claims 51 to 54, wherein the first contact layer is formed in step (d) by sputtering.

56. Use of a semiconductive conjugated polymer as at least part of an emissive semiconductive layer in an optical device, wherein the semiconductive conjugated polymer comprises arylene vinylene units forming at least part of the polymer main chain, in which an electron-withdrawing group is conjugatively linked to at least some of the vinylene moieties, and a solubilising group is present on at least some of the arylene moieties so as to render the polymer solution processible in either a polar solvent or a non-polar solvent, with the proviso that if the solubilising group is alkoxy, it has more than 4 carbon atoms.

57. Use according to claim 56, wherein the semiconductive conjugated polymer is as defined in any one of claims 2 to 28.

58. Use according to claim 56, wherein the semiconductive conjugated polymer is obtainable by a method according to any one of claims 29 to 39.

## Patentansprüche

1. Halbleitendes, konjugiertes Polymer, das Arylen-Vinylen-Einheiten umfasst, die mindestens einen Teil der Hauptkette des Polymers bilden, wobei eine lösliche Gruppe bei mindestens einigen der Arylen-Einheiten vorhanden ist, um somit die Verarbeitbarkeit des Polymers sowohl in polarem als auch in unpolaren Lösungsmitteln zu gewährleisten, mit der Vorgabe, dass die lösliche Gruppe mehr als 4 Kohlenstoffatome besitzt, wenn es sich um eine Alkoxy-Gruppe handelt, und eine Elektronen anziehende Gruppe mit mindestens einigen der Vinylen-Einheiten konjugiert verknüpft ist, wobei die lösliche Gruppe und die Elektronen anziehende Gruppe so ausgewählt sind, dass das Polymer Strahlung aussendet, wenn es zur Lumineszenz angeregt wird.

2. Halbleitendes, konjugiertes Polymer gemäß Anspruch 1, wobei die Elektronen anziehende Gruppe ausgewählt ist, um die optischen Eigenschaften des Polymers zu regulieren.

3. Halbleitendes, konjugiertes Polymer gemäß Anspruch 2, wobei die Elektronen anziehende Gruppe ausgewählt ist, um die Wellenlänge der Strahlung, die bei der Elektrolumineszenz ausgestrahlt wird, zu regulieren.

4. Halbleitendes, konjugiertes Polymer gemäß einem oder mehreren der vorangegangenen Ansprüche, wobei die Elektronen anziehende Gruppe eine Nitril-Gruppe, eine Ester-Gruppe, eine Säureamid-, eine Sulfon-, ein Sulfoxid-, eine Trifluormethyl-, eine Posphinoyl-, eine Phosphonat- oder eine Keto-Gruppe umfasst.

5. Halbleitendes, konjugiertes Polymer gemäß einem oder mehreren der vorangegangenen Ansprüche, wobei die lösliche Gruppe eine Alkoxy- oder eine Alkyl-Gruppe mit mehr als 4 Kohlenstoffatomen umfasst.

6. Halbleitendes, konjugiertes Polymer gemäß einem oder mehreren der vorangegangenen Ansprüche, wobei das Polymer mindestens einige Bereiche mit
- Ar - CX = RC- Ar' - CR = CX -
umfasst, bei denen Ar und Ar' gleich oder verschieden sind und Arylen-Einheiten oder Arylen enthaltende Einheiten darstellen, von denen mindestens einige mit einer löslichen Gruppe substituiert sind, X eine Elektronen anziehende Gruppe ist und R einen Alkyl-, Aryl- oder Wasserstoff-Rest ist.

7. Halbleitendes, konjugiertes Polymer gemäß einem oder mehreren der vorangegangenen Ansprüche, welches im wesentlichen vollständig konjugiert ist und die folgende allgemeine Formel besitzt:
-[ Ar - Vinylen - Ar' - Vinylen]ₙ-,
wobei Ar und Ar' gleich oder verschieden sind und Arylen-Gruppen darstellen, jedes Vinylen mit einer Elektronen anziehenden Gruppe X substituiert ist und n den Grad der Polymerisation darstellt.

8. Halbleitendes, konjugiertes Polymer gemäß einem oder mehreren der vorangegangenen Ansprüche, das die allgemeine Formel besitzt:
-[Ar -CX = CH - Ar' -CH = CX ]ₙ- .

9. Halbleitendes, konjugiertes Polymer gemäß Anspruch 8, wobei Ar und Ar' beide 2,5-Dihexyloxy-',⁴-Phenylen-Einheiten sind und X ein CN-Rest ist.

10. Halbleitendes, konjugiertes Polymer gemäß Anspruch 8, wobei Ar 2-Dodecyloxy-5-Methylthio-1,4-Phenylen ist, Ar' 2,5-Dihexyloxy-1,4-Phenylen und X ein CN-Rest ist.

11. Halbleitendes, konjugiertes Polymer gemäß Anspruch 8, wobei Ar 2,6-Dihexyloxy-1,5-Naphthalen ist, Ar' 2,5-Dihexyloxy-1,4-Phenylen und X ein CN-Rest ist.

12. Halbleitendes, konjugiertes Polymer gemäß Anspruch 8, wobei Ar ein 2,5-Dihexyloxy-1,4-Phenylen ist, Ar' ein 3-Dodecyl-substituiertes 2,5-Thiophen und X ein CN-Rest ist.

13. Halbleitendes, konjugiertes Polymer gemäß Anspruch 8, wobei Ar ein 3-Dodecyl-substituiertes 2,5-Thiophen ist, Ar' ein 2,5-Dihexyloxy-1,4-Phenylen und X ein CN-Rest ist.

14. Halbleitendes, konjugiertes Polymer gemäß Anspruch 8, wobei Ar ein 2,5-Diisopropyl-1,4-Phenylen ist, Ar' ein 2,5-Dihexyloxy-1,4-Phenylen und X ein CN-Rest ist.

15. Halbleitendes, konjugiertes Polymer gemäß Anspruch 8, wobei Ar ein 2-Methoxy-5-Methyl-1,3-Phenylen ist, Ar' ein 2,5-Dihexyloxy-1,4-Phenylen und X ein CN-Rest ist.

16. Halbleitendes, konjugiertes Polymer gemäß Anspruch 8, wobei Ar ein 1,3-verknüpftes Phenylen ist, Ar' ein 2,5-Dihexyloxy-1,4-Phenylen und X ein CN-Rest ist.

17. Halbleitendes, konjugiertes Polymer gemäß Anspruch 8, wobei Ar ein 2,5-Diisopropyl-1,4-Phenylen ist, Ar' ein 2-Octyloxy-5-Methyl-1,3-Phenylen und X ein CN-Rest ist.

18. Halbleitendes, konjugiertes Polymer gemäß Anspruch 8, wobei Ar ein 2-Methylthio-5-Dodecyloxy-1,4-Phenylen ist, Ar' ein 2,5-Dihexyloxy-1,4-Phenylen und X eine CN-Rest ist.

19. Halbleitendes, konjugiertes Polymer gemäß Anspruch 8, wobei Ar ein 1,3-verknüpftes Phenylen ist, Ar' ein 2,5-Diisopropyl-1,4-Phenylen und X ein CN-Rest ist.

20. Halbleitendes, konjugiertes Polymer gemäß Anspruch 8, wobei Ar ein 2-Methoxy-5-Methyl-1,3-Phenylen ist, Ar' ein 2,5-Diisopropyl-1,4-Phenylen und X ein CN-Rest ist.

21. Halbleitendes, konjugiertes Polymer gemäß Anspruch 8, wobei Ar und Ar' beide 3-Dodecyl-2,5-Thiophen sind und X ein CN-Rest ist.

22. Halbleitendes, konjugiertes Polymer gemäß Anspruch 8, wobei Ar und Ar' beide 2,5-Diisopropyl-1,4-Phenylen sind und X ein CN-Rest ist.

23. Halbleitendes, konjugiertes Polymer gemäß Anspruch 8, wobei Ar und Ar' beide 2-Methoxy-5-(2'-Äthylhexyloxy)-1,4-Phenylen sind und X ein CN-Rest ist.

24. Halbleitendes, konjugiertes Polymer gemäß Anspruch 7, welches Poly-(2,5-Hexyloxy-Cyano-Terephthalyliden) umfasst.

25. Halbleitendes, konjugiertes Polymer gemäß einem oder mehreren der Ansprüche 1 bis 5, welches nicht konjugierte Bereiche und konjugierte Bereiche, die in den Arylen-Vinylen-Einheiten eingebaut sind, umfasst.

26. Halbleitendes, konjugiertes Polymer gemäß Anspruch 25, wobei die konjugierten Bereiche Distyrylbenzol-Einheiten, welche in die Aryl-Vinyl-Einheiten eingebaut sind, umfassen.

27. Halbleitendes, konjugiertes Polymer gemäß Anspruch 26, das die folgende allgemeine Formel besitzt: 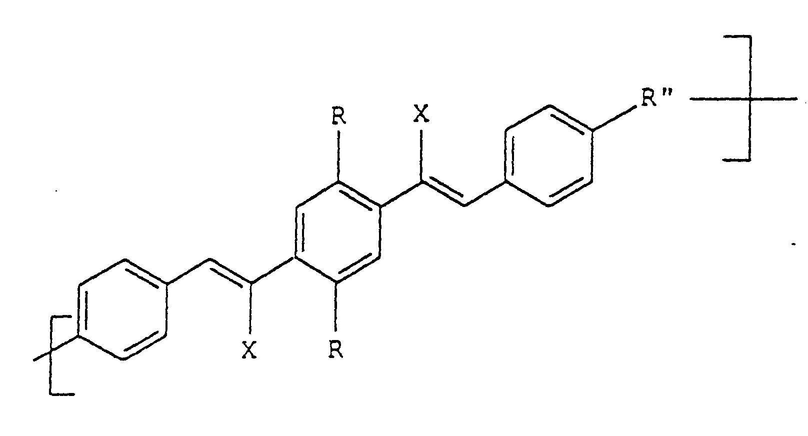 , in der mindestens einer der Reste R und R' eine lösliche Gruppe ist, X die Elektronen anziehende Gruppe und R" eine aliphatische Verknüpfungsgruppe ist.

28. Halbleitendes, konjugiertes Polymer gemäß Anspruch 27, wobei R und R' beide Hexyloxy-Gruppen sind, X ein CN-Rest und R" - O - (CH₂)₈ - O - ist.

29. Verfahren zur Herstellung eines halbleitenden, konjugierten Polymers gemäß Anspruch 1, wobei das Verfahren die Reaktion einer ersten Verbindung mit der allgemeinen Formel
X - CH₂ - Ar - CH₂ - X
mit einer zweiten Verbindung der allgemeinen Formel
O = (R) C- Ar' - C (R) = O
unter solchen den Bedingungen umfasst, dass ein Polymer produziert wird, das mindestens einige Bereiche
- Ar - CX = RC - Ar' - CR = CX -
aufweist, bei denen Ar und Ar' gleich oder verschieden sind und Arylen-Einheiten oder Arylen enthaltende Einheiten darstellen, von denen mindestens einige mit einer löslichen Gruppe substituiert sind, X eine Elektronen anziehende Gruppe und R ein Alkyl- Aryl oder Wasserstoff-Rest ist.

30. Verfahren gemäß Anspruch 29, wobei die Reaktion unter basischer Katalyse durchgeführt wird.

31. Verfahren gemäß Anspruch 30, wobei die Base Kalium-t-Butoxid, tetra-N-Butylammoniumhydroxid oder Mischungen daraus umfasst.

32. Verfahren gemäß einem oder mehreren der Ansprüche 29 bis 31, welches in Gegenwart von t-Butylalkohol und/oder THF als Lösungsmittel-Verbindungen durchgeführt wird.

33. Verfahren gemäß einem oder mehreren der Ansprüche 29 bis 32, welches in einem Temperaturbereich von 20 bis 60 °C durchgeführt wird.

34. Verfahren gemäß einem oder mehreren der Ansprüche 29 bis 33, wobei R Wasserstoff ist.

35. Verfahren gemäß einem oder mehreren der Ansprüche 29 bis 34, wobei X eine Nitril-Gruppe, eine Ester-Gruppe, eine Säureamid-, eine Sulfon-, eine Sulfoxid-, eine Phosphinoyl-, eine Phosphonat- oder eine Keto-Gruppe umfasst.

36. Verfahren gemäß einem oder mehreren der Ansprüche 29 bis 35, wobei die lösliche Gruppe eine Alkoxy- oder eine Alkylgruppe mit 4 oder mehr Kohlenstoffatomen umfasst.

37. Verfahren gemäß einem oder mehreren der Ansprüche 29 bis 36, wobei Ar und Ar', wie es in einem oder mehreren der Ansprüche 9 bis 24 definiert wurde, vorliegen und X ein CN-Rest ist.

38. Verfahren gemäß einem oder mehreren der Ansprüche 29 bis 36, wobei Ar' die Einheit Ar"-R"-Ar"' umfasst, bei der Ar" und Ar''' gleichartig oder verschieden sind und Arylen-Einheiten darstellen und R" eine aliphatische Verknüpfungsgruppe darstellt.

39. Verfahren gemäß Anspruch 38, wobei Ar" und Ar''' beide p-Phenylen sind, X ein CN-Rest und R" - O - (CH₂)₈ - O - ist.

40. Optische Vorrichtung, welche eine erste Kontaktschicht und eine halbleitende Schicht, die sich in Kontakt mit der ersten Kontaktschicht befindet, umfasst, wobei die halbleitende Schicht eine emittierende Schicht eines halbleitenden, konjugierten Polymers umfasst, das Arylen-Vinyl-Einheiten, die mindestens einen Teil der Hauptkette des Polymers bilden, ein lösliche Gruppe, die mindestens bei einigen der Arylen-Einheiten vorliegt, um somit die Verarbeitbarkeit des Polymers sowohl in polarem als auch in unpolaren Lösungsmitteln zu gewährleisten, mit der Vorgabe, dass die lösliche Gruppe, wenn es sich um eine Alkoxy-Gruppe handelt, mehr als 4 Kohlenstoffatome besitzt, und eine Elektronen anziehende Gruppe mit mindestens einigen der Vinylen-Einheiten konjugiert verknüpft ist, so dass das Polymer Strahlung aussendet, wenn es zur Lumineszenz angeregt wird.

41. Optische Vorrichtung gemäß Anspruch 40, wobei das halbleitende, konjugierte Polymer so vorliegt, wie es in einem oder mehreren der Ansprüche 2 bis 28 definiert wurde.

42. Optische Vorrichtung gemäß Anspruch 40, wobei das halbleitende, konjugierte Polymer nach einem Verfahren gemäß einem oder mehreren der Ansprüche 29 bis 39 erhalten werden kann.

43. Optische Vorrichtung gemäß einem oder mehreren der Ansprüche 40 bis 42, die eine photolumineszierende Vorrichtung umfasst, wobei das Polymer zur Lumineszenz angeregt wird, nachdem es Strahlung ausgesetzt wurde.

44. Optische Vorrichtung gemäß einem oder mehreren der Ansprüche 40 bis 42, die eine elektrolumineszierende Vorrichtung umfasst, bei der die erste Kontaktschicht sich in Kontakt mit einer ersten Oberfläche der halbleitenden Schicht befindet und eine zweite Kontaktschicht sich in Kontakt mit einer zweiten Oberfläche der halbleitenden Schicht befindet, so dass das Polymer Strahlung aussendet, nachdem ein elektrisches Feld zwischen die erste und die zweite Kontaktschicht angelegt wurde.

45. Optische Vorrichtung gemäß Anspruch 44, wobei die halbleitende Schicht darüber hinaus eine Elektronenlücken transportierende Polymerschicht zwischen der emittierenden Schicht und der ersten Kontaktschicht umfasst, wobei die Elektronenlücken transportierende Polymerschicht die erste Kontaktschicht für die Lochwanderung anpasst.

46. Optische Vorrichtung gemäß Anspruch 45, wobei die erste Kontaktschicht Indium-Zinn-Oxid umfasst und das Elektronenlücken transportierende Polymer Poly(paraphenylenvinylen), Polythiophen oder Polyphenylen umfasst.

47. Optische Vorrichtung gemäß einem oder mehreren der Ansprüche 44 bis 46, wobei die zweite Kontaktschicht ein Metall, ausgewählt aus Aluminium und Gold, umfasst.

48. Optische Vorrichtung gemäß Anspruch 47, wobei die zweite Kontaktschicht Aluminium umfasst.

49. Optische Vorrichtung gemäß einem oder mehreren der Ansprüche 44 bis 48, wobei die zweite Kontaktschicht auch mit einem Substrat in Kontakt ist.

50. Optische Vorrichtung gemäß Anspruch 49, wobei das Substrat Silizium oder Germanium umfasst.

51. Verfahren zur Herstellung einer optischen Vorrichtung gemäß Anspruch 49 oder 50, wobei die Methode umfasst:
a) das Zusammenbringen der zweiten Kontaktschicht mit dem Substrat;
b) die Ausbildung einer Schicht des halbleitenden, konjugierten Polymers auf der zweiten Kontaktschicht;
c) die Ausbildung einer Schicht eines Elektronenlücken transportierenden Polymers auf der Schicht des halbleitenden, konjugierten Polymers; und
d) die Ausbildung der ersten Kontaktschicht auf der Schicht des Elektronenlücken transportierenden Polymers.

52. Verfahren gemäß Anspruch 51, wobei die zweite Kontaktschicht auf das Substrat in Schritt a) aufgedampft wird.

53. Verfahren gemäß Anspruch 51 oder 52, wobei das halbleitende, konjugierte Polymer in Schritt b) aus einer Lösung gebildet wird.

54. Verfahren gemäß einem oder mehreren der Ansprüche 51 bis 53, wobei das Elektronenlücken transportierende Polymer in Schritt c) in Form einer löslichen Vorläuferverbindung erhalten wird, die anschließend thermisch umgewandelt wird, um das Elektronenlücken transportierenden Polymer auszubilden.

55. Verfahren gemäß einem oder mehreren der Ansprüche 51 bis 54, wobei die erste Kontaktschicht in Schritt d) durch Beschichten (Sputtern) ausgebildet wird.

56. Verwendung eine halbleitenden, konjugierten Polymers als mindestens ein Bestandteil einer emittierenden, halbleitenden Schicht in einer optischen Vorrichtung, wobei das halbleitende, konjugierte Polymer Arylen-Vinylen-Einheiten umfasst, die mindestens einen Teil der Hauptkette des Polymers bilden, in der eine Elektronen anziehende Gruppe mit mindestens einigen Vinylen-Einheiten konjugiert verknüpft ist und eine lösliche Gruppe in mindestens einigen Arylen-Einheiten präsent ist, um somit die Verarbeitbarkeit des Polymers sowohl in polarem als auch in unpolaren Lösungsmitteln zu gewährleisten, mit der Vorgabe, dass die lösliche Gruppe, wenn es sich um eine Alkoxy-Gruppe handelt, mehr als 4 Kohlenstoffatome besitzt.

57. Verwendung gemäß Anspruch 56, wobei das halbleitende, konjugierte Polymer so vorliegt, wie es in einem oder mehreren der Ansprüche 2 bis 28 definiert wurde.

58. Verwendung gemäß Anspruch 56, wobei das halbleitende, konjugierte Polymer nach einem Verfahren gemäß einem oder mehreren der Ansprüche 29 bis 39, erhalten werden kann.

## Revendications

1. Polymère conjugué semiconducteur comprenant des motifs arylène-vinylène formant au moins une partie de la chaîne principale du polymère, dans lequel un groupe solubilisant est présent sur au moins certains des groupements arylène de manière à rendre la solution de polymère apte au traitement dans un solvant polaire ou un solvant non polaire, sous réserve que, si le groupe solubilisant est un groupe alkoxy, il ait plus de 4 atomes de carbone, et un groupe électrophile est lié par conjugaison à au moins certains des groupements vinylène, le groupe solubilisant et le groupe électrophile étant choisis de telle sorte que le polymère émette un rayonnement lors de son excitation à l'état de luminescence.

2. Polymère conjugué semiconducteur suivant la revendication 1, dans lequel le groupe électrophile est choisi de manière à moduler les propriétés optiques du polymère.

3. Polymère conjugué semiconducteur suivant la revendication 2, dans lequel le groupe électrophile est choisi de manière à moduler la longueur d'onde du rayonnement émis en électroluminescence.

4. Polymère conjugué semiconducteur suivant l'une quelconque des revendications précédentes, dans lequel le groupe électrophile comprend un groupe nitrile, un groupe ester, un groupe amide d'acide, un groupe sulfone, un groupe sulfoxyde, un groupe trifluorométhyle, un groupe phosphinoyle, un groupe phosphonate ou un groupe cétone.

5. Polymère conjugué semiconducteur suivant l'une quelconque des revendications précédentes, dans lequel le groupe solubilisant comprend un groupe alkoxy ou alkyle ayant plus de 4 atomes de carbone.

6. Polymère conjugué semiconducteur suivant l'une quelconque des revendications précédentes, qui comprend au moins certaines régions de formule
**-Ar-CX = RC-Ar'-CR = CX-**
dans laquelle Ar et Ar' sont identiques ou différents et représentent des groupements arylène ou groupements à fonction arylène, dont au moins certains sont substitués avec un groupe solubilisant, X représente un groupe électrophile et R représente un groupe alkyle, un groupe aryle ou l'hydrogène.

7. Polymère conjugué semiconducteur suivant l'une quelconque des revendications précédentes, qui est pratiquement totalement conjugué et qui répond à la formule générale suivante : 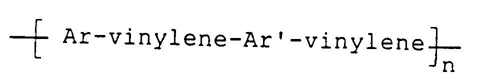 dans laquelle Ar et Ar' sont identiques ou différents et représentent des groupes arylène, chaque groupe vinylène est substitué avec le groupe électrophile X, et n représente le degré de polymérisation.

8. Polymère conjugué semiconducteur suivant l'une quelconque des revendications précédentes, répondant à la formule générale :

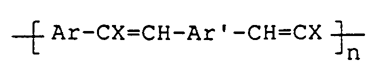

9. Polymère conjugué semiconducteur suivant la revendication 8, dans lequel Ar et Ar' représentent l'un et l'autre un groupement 2,5-dihexyloxy-1,4-phénylène et X représente un groupe CN.

10. Polymère conjugué semiconducteur suivant la revendication 8, dans lequel Ar représente un groupe 2-dodécyloxy-5-méthylthio-1,4-phénylène, Ar' représente un groupe 2,5-dihexyloxy-1,4-phénylène et X représente un groupe CN.

11. Polymère conjugué semiconducteur suivant la revendication 8, dans lequel Ar représente un groupe 2,6-dihexyloxy-1,5-naphtalène, Ar' représente un groupe 2,5-dihexyloxy-1,4-phénylène et X représente un groupe CN.

12. Polymère conjugué semiconducteur suivant la revendication 8, dans lequel Ar représente un groupe 2,5-dihexyloxy-1,4-phénylène, Ar' représente un groupe 3-dodécyl-substitué-2,5-thiophène et X représente un groupe CN.

13. Polymère conjugué semiconducteur suivant la revendication 8, dans lequel Ar représente un groupe 3-dodécyl-substitué-2,5-thiophène, Ar' représente un groupe 2,5-dihexyloxy-1,4-phénylène et X représente un groupe CN.

14. Polymère conjugué semiconducteur suivant la revendication 8, dans lequel Ar représente un groupe 2,5-diisopropyl-1,4-phénylène, Ar' représente un groupe 2,5-dihexyloxy-1,4-phénylène et X représente un groupe CN.

15. Polymère conjugué semiconducteur suivant la revendication 8, dans lequel Ar représente un groupe 2-méthoxy-5-méthyl-1,3-phénylène, Ar' représente un groupe 2,5-dihexyloxy-1,4-phénylène et X représente un groupe CN.

16. Polymère conjugué semiconducteur suivant la revendication 8, dans lequel Ar représente un groupe phénylène lié en position 1,3, Ar' représente un groupe 2,5-dihexyloxy-1,4-phénylène et X représente un groupe CN.

17. Polymère conjugué semiconducteur suivant la revendication 8, dans lequel Ar représente un groupe 2,5-diisopropyl-1,4-phénylène, Ar' représente un groupe 2-octyloxy-5-méthyl-1,3-phénylène et X représente un groupe CN.

18. Polymère conjugué semiconducteur suivant la revendication 8, dans lequel Ar représente un groupe 2-méthylthio-5-dodécyloxy-1,4-phénylène, Ar' représente un groupe 2,5-dihexyloxy-1,4-phénylène et X représente un groupe CN.

19. Polymère conjugué semiconducteur suivant la revendication 8, dans lequel Ar représente un groupe phénylène lié en position 1,3, Ar' représente un groupe 2,5-diisopropyl-1,4-phénylène et X représente un groupe CN.

20. Polymère conjugué semiconducteur suivant la revendication 8, dans lequel Ar représente un groupe 2-méthoxy-5-méthyl-1,3-phénylène, Ar' représente un groupe 2,5-diisopropyl-1,4-phénylène et X représente un groupe CN.

21. Polymère conjugué semiconducteur suivant la revendication 8, dans lequel Ar et Ar' représentent l'un et l'autre un groupe 3-dodécyl-2,5-thiophène et X représente un groupe CN.

22. Polymère conjugué semiconducteur suivant la revendication 8, dans lequel Ar et Ar' représentent l'un et l'autre un groupe 2,5-diisopropyl-1,4-phénylène et X représente un groupe CN.

23. Polymère conjugué semiconducteur suivant la revendication 8, dans lequel Ar et Ar' représentent l'un et l'autre un groupe 2-méthoxy-5-(2'-éthylhexyloxy)-1,4-phénylène et X représente un groupe CN.

24. Polymère conjugué semiconducteur suivant la revendication 7, qui comprend le poly(2,5-hexyloxy-cyanotéréphtalylidène).

25. Polymère conjugué semiconducteur suivant l'une quelconque des revendications 1 à 5, qui comprend des régions non conjuguées et des régions conjuguées renfermant les motifs arylène-vinylène.

26. Polymère conjugué semiconducteur suivant la revendication 25, dans lequel les régions conjuguées comprennent des groupements distyrylbenzène qui renferment les motifs arylène-vinylène.

27. Polymère conjugué semiconducteur suivant la revendication 26, répondant à la formule générale suivante: 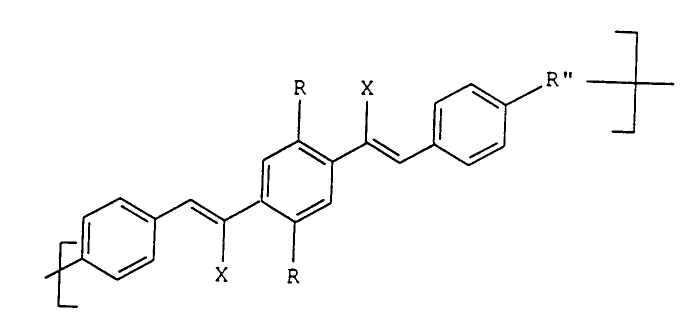 dans laquelle au moins un des groupes R et R' représente un groupe solubilisant, X représente le groupe électrophile et R" représente un groupe aliphatique de liaison.

28. Polymère conjugué semiconducteur suivant la revendication 27, dans lequel R et R' représentent l'un et l'autre un groupe hexyloxy, X représente un groupe CN et R" représente un groupe -O-(CH₂)₈-O-.

29. Procédé pour la préparation d'un polymère conjugué semiconducteur suivant la revendication 1, procédé qui comprend la réaction d'un premier composé de formule générale
**X-CH**_{**2**}**-Ar-CH**_{**2**}**-X**
avec un second composé de formule générale
**O=(R)C-Ar'-C(R)=O**
dans des conditions permettant de produire un polymère comprenant au moins certaines régions de formule
**-Ar-CX = RC-Ar'-CR = CX-**
dans laquelle Ar et Ar' sont identiques ou différents et représentent des groupements arylène ou des groupements à fonction arylène, dont au moins certains sont substitués avec un groupe solubilisant, X représente un groupe électrophile et R représente un groupe alkyle, un groupe aryle ou l'hydrogène.

30. Procédé suivant la revendication 29, dans lequel la réaction est conduite dans des conditions de catalyse avec une base.

31. Procédé suivant la revendication 30, dans lequel la base comprend le tertio-butylate de potassium, l'hydroxyde de tétra-N-butylammonium ou leurs mélanges.

32. Procédé suivant l'une quelconque des revendications 29 à 31, qui est mis en oeuvre en présence d'alcool tertio-butylique et/ou de THF comme constituants servant de solvants.

33. Procédé suivant l'une quelconque des revendications 29 à 32, qui est mis en oeuvre à une température comprise dans la plage de 20 à 60°C.

34. Procédé suivant l'une quelconque des revendications 29 à 33, dans lequel R représente l'hydrogène.

35. Procédé suivant l'une quelconque des revendications 29 à 34, dans lequel X comprend un groupe nitrile, un groupe ester, un groupe amide d'acide, un groupe sulfone, un groupe sulfoxyde, un groupe trifluorométhyle, un groupe phosphinoyle, un groupe phosphonate ou un groupe cétone.

36. Procédé suivant l'une quelconque des revendications 29 à 35, dans lequel le groupe solubilisant comprend un groupe alkoxy ou alkyle ayant 4 ou plus de 4 atomes de carbone.

37. Procédé suivant l'une quelconque des revendications 29 à 36, dans lequel Ar et Ar' répondent aux définitions suivant l'une quelconque des revendications 9 à 24, et X représente un groupe CN.

38. Procédé suivant l'une quelconque des revendications 29 à 36, dans lequel Ar' comprend le motif Ar"-R"-Ar''' dans lequel Ar" et Ar''' sont identiques ou différents et représentent des groupements arylène, et R" représente un groupe aliphatique de liaison.

39. Procédé suivant la revendication 38, dans lequel Ar" et Ar''' représentent l'un et l'autre un groupe p-phénylène, X représente un groupe CN et R" représente un groupe -O-(CH₂)₈-O-.

40. Dispositif optique qui comprend une première couche de contact, une couche semiconductrice en contact avec la première couche de contact, dans lequel la couche semiconductrice comprend une couche émissive d'un polymère conjugué semiconducteur comprenant des motifs arylène-vinylène formant au moins une partie de la chaîne principale du polymère, un groupe solubilisant est présent sur au moins certains des groupements arylène de manière à rendre la solution de polymère apte au traitement dans un solvant polaire ou un solvant non polaire, sous réserve que, si le groupe solubilisant est un groupe alkoxy, il ait plus de 4 atomes de carbone, et un groupe électrophile est lié par conjugaison à au moins certains des groupements vinylène de telle sorte que le polymère émette un rayonnement lors de son excitation à l'état de luminescence.

41. Dispositif optique suivant la revendication 40, dans lequel le polymère conjugué semiconducteur répond à la définition suivant l'une quelconque des revendications 2 à 28.

42. Dispositif optique suivant la revendication 40, dans lequel le polymère conjugué semiconducteur peut être obtenu par un procédé suivant l'une quelconque des revendications 29 à 39.

43. Dispositif optique suivant l'une quelconque des revendications 40 à 42, comprenant un dispositif photoluminescent dans lequel le polymère est excité à l'état de luminescence par application d'un rayonnement à ce polymère.

44. Dispositif optique suivant l'une quelconque des revendications 40 à 42, comprenant un dispositif électroluminescent dans lequel la première couche de contact est en contact avec une première surface de la couche semiconductrice, et une seconde couche de contact est en contact avec une seconde surface de la couche semiconductrice, de telle sorte que le polymère émette un rayonnement par application d'un champ électrique entre les première et seconde couches de contact.

45. Dispositif optique suivant la revendication 44, dans lequel la couche semiconductrice comprend en outre une couche d'un polymère de transport de lacunes entre la couche émissive et la première couche de contact, couche de polymère de transport de lacunes qui s'adapte à la première couche de contact pour l'injection de lacunes.

46. Dispositif optique suivant la revendication 45, dans lequel la première couche de contact comprend de l'oxyde d'indium-étain et le polymère de transport de lacunes comprend un poly(paraphénylènevinylène), polythiophène ou polyphénylène.

47. Dispositif optique suivant l'une quelconque des revendications 44 à 46, dans lequel la seconde couche de contact comprend un métal choisi entre l'aluminium et l'or.

48. Dispositif optique suivant la revendication 47, dans lequel la seconde couche de contact comprend de l'aluminium.

49. Dispositif optique suivant l'une quelconque des revendications 44 à 48, dans lequel la seconde couche de contact est également en contact avec un substrat.

50. Dispositif optique suivant la revendication 49, dans lequel le substrat comprend le silicium ou le germanium.

51. Procédé pour la production d'un dispositif optique suivant la revendication 49 ou la revendication 50, procédé qui comprend les étapes consistant :
(a) à mettre la seconde couche de contact en contact avec le substrat ;
(b) à former une couche du polymère conjugué semiconducteur sur la seconde couche de contact ;
(c) à former une couche du polymère de transport de lacunes sur la couche du polymère conjugué semiconducteur ; et
(d) à former la première couche de contact sur la couche du polymère de transport de lacunes.

52. Procédé suivant la revendication 51, dans lequel la seconde couche de contact est appliquée par évaporation sur le substrat dans l'étape (a).

53. Procédé suivant la revendication 51 ou la revendication 52, dans lequel le polymère conjugué semiconducteur est formé dans l'étape (b) à partir d'une solution.

54. Procédé suivant l'une quelconque des revendications 51 à 53, dans lequel le polymère de transport de lacunes est appliqué dans l'étape (c) sous forme d'un précurseur soluble qui est ensuite soumis à une conversion thermique pour former le polymère de transport de lacunes.

55. Procédé suivant l'une quelconque des revendications 51 à 54, dans lequel la première couche de contact est formée dans l'étape (d) par pulvérisation cathodique.

56. Utilisation d'un polymère conjugué semiconducteur en tant qu'au moins une partie d'une couche semiconductrice émissive dans un dispositif optique, dans laquelle le polymère conjugué semiconducteur comprend des motifs arylène-vinylène formant au moins une partie de la chaîne principale du polymère, un groupe électrophile étant lié par conjugaison à au moins certains des groupements vinylène, et un groupe solubilisant étant présent sur au moins certains des groupements arylène de manière à rendre la solution de polymère apte au traitement dans un solvant polaire ou un solvant non polaire, sous réserve que, si le groupe solubilisant est un groupe alkoxy, il ait plus de 4 atomes de carbone.

57. Utilisation suivant la revendication 56, dans laquelle le polymère conjugué semiconducteur répond à la définition suivant l'une quelconque des revendications 2 à 28.

58. Utilisation suivant la revendication 56, dans laquelle le polymère conjugué semiconducteur peut être obtenu par un procédé suivant l'une quelconque des revendications 29 à 39.
